# EUROPEAN PATENT APPLICATION

(11) **EP 4 435 975 A1**
(43) Date of publication of application: **25.09.2024**
(21) Application number: 23164140.8
(22) Date of filing: 24.03.2023
(51) Int. Cl.: H01R 4/64, F16J 15/08, H05K 5/06, B60R 16/00

(54) **GASKET AND USE OF THE GASKET AND ASSEMBLY WITH GASKET**

(71) Applicant: ElringKlinger (Great Britain) Ltd., Redcar, Cleveland TS10 5RX (GB); ElringKlinger AG, 72581 Dettingen (DE)
(72) Inventor: Rimington, Darren, Redcar, Cleveland, TS10 5RX (GB)
(74) Representative: Pfiz/Gauss Patentanwälte PartmbB

(57) **Abstract**

A gasket, in particular gasket for an electrical assembly and/or an automotive assembly, for sealing between at least two mating parts, is provided wherein the gasket comprises a sealing section and at least one electrically connecting unit, wherein the sealing section comprises a first group of at least one sealing face for one of the at least two mating parts and a second group of at least one sealing face for the other of the at least two mating parts and wherein the at least one electrically connecting unit comprises a first group of at least one electrically conductive contacting face for the one of the two mating parts and a second group of at least one electrically conductive contacting face for the other of the at least two mating parts, wherein at least one sealing face of the first group and at least one electrically conductive contacting face of the first group are different faces and/or at least one sealing face of the second group and at least one electrically conductive contacting face of the second group are different faces.

## Description

The invention relates to a gasket, a use of a gasket and an assembly with a gasket. In particular, the gasket is a gasket for an electrical assembly and/or an automotive assembly. Advantageously, the use of the gasket is in an electrical assembly and/or an automotive assembly. In particular, the assembly is an electrical assembly and/or an automotive assembly.

The problem underlying the invention is to provide an improved gasket and an improved use of a gasket and an improved assembly.

In embodiments of the invention the underlying problem is solved by a gasket, in particular a gasket for an electrical assembly and/or an automotive assembly, the gasket is configured for sealing between at least two mating parts, and in particular the gasket is configured for electrically connecting the at least two mating parts, wherein the gasket comprises a sealing section and at least one electrically connecting unit, wherein the sealing section comprises a first group of at least one sealing face for one of the at least two mating parts and a second group of at least one sealing face for the other of the at least two mating parts and wherein the at least one electrically connecting unit comprises a first group of at least one electrically conductive contacting face for one of the two mating parts and a second group of at least one electrically conductive contacting face for the other of the at least two mating parts, wherein at least one sealing face of the first group and at least one electrically conductive contacting face of the first group are different faces and/or at least one sealing face of the second group and at least one electrically conductive contacting face of the second group are different faces.

In embodiments of the invention the underlying problem is solved by a use of a gasket for sealing between at least two mating parts and electrically connecting the at least two mating parts, in particular a use in an electrical assembly and/or in an automotive assembly wherein the gasket comprises a sealing section for sealing between the at least two mating parts and at least one electrically connecting unit for electrically connecting the at least two mating parts, wherein the sealing section comprises a first group of at least one sealing face for one of the two mating parts and a second group of at least one sealing face for the other of the at least two mating parts and wherein in use the at least one sealing face of the first group is arranged in a sealed manner with the one of the at least two mating parts and the at least one sealing face of the second group is arranged in a sealed manner with the other of the at least two mating parts, and wherein the electrically connecting unit comprises a first group of at least one electrically conductive contacting face for one of the two mating parts and a second group of at least one electrically conductive contacting face for the other of the at least two mating parts and wherein in use the at least one electrically conductive contacting face of the first group is arranged in electrically conductive contact with the one of the at least two mating parts and the at least one electrically conductive contacting face of the second group is arranged in an electrically conductive contact with the other of the at least two mating parts, and wherein at least one sealing face of the first group and the at least one electrically conductive contacting face of the first group are different faces and/or at least one sealing face of the second group and at least one electrically conductive contacting face of the second group are different faces.

In embodiments of the invention the underlying problem is solved by an assembly, in particular an electrical assembly and/or an automotive assembly, the assembly comprising at least two mating parts and a gasket for sealing at least between the at least two mating parts, wherein the gasket comprises a sealing section and at least one electrically connecting unit, wherein the sealing section comprises a first group of at least on sealing face for one of the at least two mating parts and a second group of at least one sealing face for the other of the at least two mating parts and wherein the at least one electrically connecting unit comprises a first group of at least one electrically conductive contacting face for one of the two mating parts and a second group of at least one electrically conductive contacting face for the other of the at least two mating parts, wherein at least one sealing face of the first group and at least one electrically conductive contacting face of the first group are different faces and/or at least one sealing face of the second group and at least one electrically conductive contacting face of the second group are different faces, and wherein at least one sealing face, in particular each of at least some, preferably of all sealing faces, of the first group is in sealing arrangement with one of the at least two mating parts and at least one sealing face, in particular each of at least some, preferably of all sealing faces, of the second group is in sealing arrangement with the other of the at least two mating parts and wherein at least one electrically conductive contacting face, in particular each of at least some, preferably of all electrically conductive contacting faces, of the first group is in electrically conductive contact with one of the at least two mating parts and at least one electrically conductive contacting face, in particular each of at least some, preferably of all electrically conductive contacting faces, of the second group is in electrically conductive contact with the other of the at least two mating parts.

In particular, one advantage of embodiments of the invention is that at least one sealing face of one group and at least one electrically conductive contacting face of one group, that are provided for a same mating part, are different faces and these faces can therefore be adapted and in particular optimized with respect to their specific function. That is the sealing face can be adapted to, in particular optimized for, sealing and the electrically conductive contacting face can be adapted to, in particular optimized for, providing a good electrically conductive contact.

In particular, because at least one sealing face and at least one electrically conductive contacting face are different faces, they can be adapted to the specific functions without compromises, allowing more advanced and/or cost efficient solutions. For example, the need for extra machined and/or high quality finished surfaces at the at least two mating parts is at least reduced or even deleted. For example, larger assemble tolerances can be allowed and therefore costs for machining the mating parts are reduced.

In particular, the gasket provides sealing against undesired mediums, in particular fluids and/or dirt particles, for example from an outside, and/or provides sealing against environmental conditions.

For example, a good conductivity between the parts and the gasket is beneficial in order to prevent issues regarding discharges and/or voltage issues.

In particular, it is beneficial to provide an electrically connection of the at least two mating parts with and in particular through the gasket, because this provides for example a flexible and/or cost-efficient solution. For example, if the at least two mating parts were assembled to be in direct contact for an electrical connection there would be higher, for example more advanced and/or more costly, requirements for the mating parts. These high requirements can for example comprise extra machine processes for contacting faces of the mating parts and/or the need of very small tolerance levels for direct contact of the at least two mating parts.

In particular, a direct contact between the at least two mating parts could provide difficulties to maintain the electrically conductivity between the at least two mating parts, because for example potential contacting faces of the at least two mating parts could move apart due to thermal elongation spreads of the materials and/or local thermal fields being different within the at least two mating parts and/or due to dynamic force conditions of the at least two mating parts and for example in the assembly due to the at least two mating parts could move away from each other resulting in at least a reduction or being in a loss of electrical conductivity.

In particular, an advantage of embodiments of the invention is that the gasket combines the sealing and conductivity function into one product. In particular, that deletes the need for separate conductive products for electrically connecting the at least two mating parts and/or the need for specific features for providing electrical conductivity at the at least two mating parts. In particular, because separate conductive products, like for example earthing chaps and/or leaf conductors, are not required extra machining processes and/or assembling processes and/or costs associated with these separate products can be avoided.

In particular, the at least one sealing face and the at least one electrically conductive contacting face that are different faces are provided for the same of the at least two mating parts.

In particular, the exactly one sealing face or the several sealing faces of the first group and the exactly one electrically conductive contacting face or the several electrically conductive contacting faces of the first group are provided for the same of the at least two mating parts, for example for a first mating part. In particular, the at least one sealing face of the first group and the at least one electrically conductive contacting face of the first group are assembled in a mounted state to a same, for example first, mating part of the at least two mating parts, in particular in a sealed manner and electrically conductive manner, respectively.

In particular, the exactly one sealing face or the several sealing faces of the second group and the exactly one electrically conductive contacting face or the several electrically conductive contacting faces of the second group, are provided for a same mating part, for example for a second mating part, of the at least two mating parts. In particular, the at least one sealing face of the second group and the at least one electrically conductive contacting face of the second group are assembled in a mounted state to a same, for example second, mating part of the at least two mating parts, in particular in a sealed manner and electrically conductive manner, respectively.

With respect to the sealing faces no further details have been given so far.

Advantageously, the at least one sealing face, preferably at least several, for example all, of the plurality of sealing faces, of the first group is/are coated with a sealing material.

In preferred embodiments, the at least one sealing face, in particular several, for example all, of the plurality of sealing faces, of the second group is/are coated with a sealing material.

In particular, therewith a sealing of the at least one sealing face is improved. Advantageously, a to be sealed face at the respective mating part is then not required to have a high quality finishing. Advantageously, the sealing material is able to seal surface imperfections at the to be sealed face of the mating part.

Preferably, the sealing material comprises and/or is a soft sealing material. For example, therewith a good micro sealing is achieved.

In some embodiments, the sealing material is at least essentially an electrically insulating material. However, therewith there is no disadvantage, because electrical conductivity is provided through the at least one electrically conductive contacting face.

In some advantageous embodiments, the sealing material comprises and for example is an elastomer, in particular comprises, for example is, a natural and/or synthetic rubber.

In particular, the gasket comprises at least one sealing segment, that is exactly one sealing segment or several sealing segments, that provides /provide the sealing faces.

In particular, a respective sealing face is provided by a sealing portion of the gasket, in particular by a sealing portion of a sealing segment.

With respect to the electrically conductive contacting faces, to which in the following it is shortly referred to as contacting faces, no further details have been provided so far.

In particular, the contacting faces are at least basically at least partly similarly built.

A reference in the following to at least one contacting face of one of the groups in connection with a feature is to be understood that at least one contacting face of the group has the described feature and preferably at least several, for example all, of a plurality of contacting faces of the group has this feature.

Advantageously, at least one contacting face of at least one of the first and/or second group has a combination of the following described features.

In some embodiments contacting faces of the same group and/or contacting faces of different groups differ in at least one feature.

In particular, at least one contacting face of the first group and/or at least one contacting face of the second group is made of an electrically conductive material.

For example, the electrically conductive material comprises and/or is a metallic material.

In particular, the at least one contacting face of the first and/or second group is an electrically, advantageously a good electrically conductive face.

In some preferred embodiments, at least one contacting face of the first group and/or at least one contacting face of the second group is a metallic face.

In preferred embodiments, at least one contacting face, for example at least one contacting face of the first group and/or at least one contacting face of the second group, is a curved face.

In particular, a radius of curvature of the curved contacting face is aligned at least approximately transverse to a lateral extent of the contacting face and/or is at least approximately aligned in a direction of a normal N of the contacting face.

In particular, the curved contacting face has a contacting region and bends away from the contacting region. The contacting region is configured to contact and/or contacts the respective mating part.

Advantageously, therewith a curved contacting face has a protruding contacting region which enables for a better contact with the respective mating part.

In particular, the gasket comprises at least one contact segment providing at least one contacting face.

Preferably, the gasket comprises a first group of at least one contact segment that provides at least one contacting face of the first group and a second group of at least one contact segment that provides at least one contacting face of the second group.

Accordingly, in particular each of the first and second group comprises exactly one contact segment or preferably several contact segments each of that providing at least one contacting face of the respective group.

Preferably, the at least one contact segment of the first group and the at least one contact segment of the second group are different segments.

Further details with respect to the arrangement of the contacting faces have not been given so far.

In particular, within the gasket there is at least one electrically conductive path between at least one contacting face of the first group and at least one contacting face of the second group.

Preferably, each contacting face of each of the first and second group is electrically connected with at least one contacting face of the other group along an electrically conductive path.

For example, at least one contacting face of the first group is electrically connected by respective electrically conductive paths to at least several contacting faces of the second group and/or at least one contacting face of the second group is electrically connected by respective electrically conductive paths to at least several contacting faces of the first group.

Advantageously, by the electrical connection of at least one contacting face of the first group with at least one contacting face of the second group the mating parts are at least in a mounted state of the assembly also electrically connected to each other because they are in an electrical contact with at least one respective contacting face.

In advantageous embodiments, at least one electrically conductive path, preferably each of at least several, for example of all, electrically conductive paths, runs at least partially through the sealing section.

Accordingly, in particular such an electrically conductive path runs from one contacting face of one of the first and second group to and through the sealing section and to a contacting face of the other of the first and second group.

For example, an advantage thereof is that the electrical connection of contacting faces of the first and second group is provided by the sealing section which the gasket anyway has and therefore further elements and/or material for the electrical connection can be avoided. In particular, this results in material and/or cost savings and/or to an easier assembling of the gasket with the two mating parts.

Preferably, at least one contacting face, in particular a contact segment providing the at least contacting face, is fixedly connected to the sealing section.

In advantageous embodiments at least one contacting face for one of the at least two mating parts, in particular a contact segment providing this at least one contacting face, is fixedly connected to a segment of the sealing section, that segment provides at least one sealing face for the other of the at least two mating parts.

Advantageously, at least one contacting face, in particular a contact segment providing this at least one contacting face, is integrally formed with at least a segment of the sealing section.

Preferably, at least one contacting face for one of the at least two mating parts, in particular a contact segment providing this at least one contacting face, is integrally formed with a segment of the sealing section which provides at least one sealing face for the other of the at least two mating parts.

In particular, at least one contacting face, in particular each of at least several, for example all, contacting faces, of the first group for one of the at least two mating parts, for example a first mating part, is fixedly connected, in particular integrally formed, with a segment, for example a second segment, of the sealing section that segment, for example the second segment, providing at least one sealing face, preferably at least several, for example all, sealing faces, of the second group for the other of the at least two mating parts, for example for the second mating part.

In particular, at least one contacting face, preferably each of at least several, for example all, contacting faces of the second group for the other, for example second, mating part of the at least two mating parts is fixedly connected, in particular integrally formed, with a segment, for example a first segment, of the sealing section, that segment, for example the first segment, provides at least one sealing face, preferably at least several, for example all, sealing faces, of the first group for the one, for example first, mating part of the at least two mating parts.

In particular, an advantage of fixedly connected, in particular integrally formed, segments which provide at least one contacting face for one of the two mating parts and at least one sealing face for another mating part than the contacting face is provided for, is that the respective segments can be specially adapted, in particular optimized, for the specific sealing and/or contacting function but for example on opposite sides and therefore the adapting for one of the two functions does not interfere with the adapting with the other function, but still the assembling is simplified, because the segments are at least fixedly connected.

In preferred embodiments the contacting faces, in particular the contact segments providing the contacting faces, of the connecting unit are arranged along the sealing section with an offset to each other. In particular, therewith the contact segments are enabled to be arranged in a contacting manner with a respective mating part.

In particular, at least one contact segment, that provides a contacting face of the first group, and at least one contact segment, that provides a contacting face of the second group, are in a crossing arrangement with respect to each other. In particular, the projection of at least one contact segment providing at least one contacting face of the first group and the projection of at least one contact segment providing at least one contacting face of the second group are crossing each other in a projection plane. In particular, the projection plane runs at least approximately perpendicular to a longitudinal extension of the sealing section and/or runs in a radial direction of a sealing axis and for example the sealing axis is aligned in the projection plane.

Advantageously, at least one contact segment which provides at least one contacting face is resiliently arranged.

In some preferred embodiments, at least one contact segment is resiliently arranged with respect to the sealing section.

Preferably, at least one contact segment that provides at least one contacting face of the first group and at least one contact segment that provides at least one contacting face of the second group are resiliently arranged with respect to each other.

In particular, with the resilient arrangement a spring like behavior of the contact segment for contacting the respective mating part is provided.

In particular, due to the resilient arrangement a contact of the contacting face with the respective mating part is more reliable und in particular an at least essentially temporal constant contact can be provided.

Advantageously, due to the resilient arrangement, in particular due to the spring behavior, of the contact segment larger tolerances for the mating part can be allowed.

For example, due to the resilient arrangement the contact segment is enabled to self-adjust to the respective mating part.

Advantageously, a free space and/or gap between the mating parts can be bridged by the in particular resiliently arranged contact segments also when the free space or gap has a varying width due to thermal elongations and/or dynamic forces acting on and/or within the respective mating parts.

In advantageous embodiments at least one contacting face of the first group and at least one sealing face of the first group are facing in different directions and/or at least one contacting face of the second group and at least one sealing face of the second group are facing in different directions.

Herein above and subsequently, different directions are in particular directions which are angled to each other with an angle of at least 20°, preferably of at least 40°, advantageously of at least 60°, in particular of at least 75°.

In particular, at least several, for example all, contacting faces of the first group are facing in a different direction than at least one sealing face, for example at least several, in particular all, sealing faces of the first group.

In particular, at least several, for example all, contacting faces of the second group are facing in a different direction than at least one sealing face, for example at least several, in particular all, sealing faces, of the second group.

In particular, at least one sealing face of the first group and/or at least one sealing face of the second group is facing at least approximately in an axial direction of a sealing axis.

In particular, at least one contacting face, in particular at least several, for example all, contacting faces of the first group and/or at least one contacting face, in particular at least several, for example all, contacting faces of the second group is/are facing at least approximately in a radial direction with respect to a sealing axis.

In particular, at least one sealing face, for example at least several, in particular all, sealing faces, of the first group is/are facing in an oriented direction which is at least approximately oppositely oriented than an oriented direction in which at least one sealing face, for example at least several, in particular all, sealing faces of the second group are facing.

In some preferred embodiments, at least one contacting face of the first group and at least one contacting face of the second group are facing in at least approximately the same oriented directions. In particular, the at least one contacting faces of the first and second group which are facing in at least approximately the same oriented directions are arranged next to each other.

In some advantageous embodiments, at least one contacting face of the first group and at least one contacting face of the second group are facing in at least approximately oppositely oriented directions. In particular, the at least one contacting faces of the first and second group which are facing in at least approximately oppositely oriented directions are arranged next to each other.

In preferred embodiments a direction, in particular a sealing direction and/or the axial direction of the sealing axis, in which at least one sealing face of the first group and at least one sealing face of the second group are facing but oppositely to each other, is a different direction than a direction in which at least one contacting face of the first group and at least one contacting face of the second group are facing but oppositely to each other.

In some preferred embodiments, at least one contacting face, preferably each of at least several, in particular of all, contacting faces of at least one group, for example of the first and/or second group, are at least approximately facing radially inwards with respect to a sealing axis.

In some preferred embodiments, at least one contacting face, preferably each of at least several, in particular of all, contacting faces, of at least one group, for example of the first und/or second group, are at least approximately facing in a radially outward direction with respect to a sealing axis.

In some advantageous embodiments, at least one contacting face of one group, for example of the first group, is facing radially inwards and at least one contacting face of the other group, for example of the second group, is facing radially outwards.

In some advantageous embodiments at least one contacting face of the first group and at least one contacting face of the second group are facing radially inwards.

In particular, at least one contact segment, in particular at least one contact segment of the first group and/or at least one contact segment of the second group, is configured to contact with its contacting face the respective mating part at a surface which is different to the surface which provides the to be sealed face of the mating part. In particular, a surface with a to be contacted face of the mating part and the surface with the to be sealed face meet each other at an edge section of the mating part.

In some preferred embodiments, at least one contacting face, in particular at least one contacting face of the first group and/or at least one contacting face of the second group, is arranged outside of a sealing plane.

In particular, the sealing plane runs at least approximately perpendicular to the sealing direction.

In particular, the sealing plane is defined by at least a subsection of the sealing section. In particular, the sealing section runs at least approximately perpendicular to the sealing direction in the subsection and/or within the sealing plane.

In particular, the contacting face that is arranged outside of the sealing plane, in particular the contact segment providing this at least one contacting face, is fixedly connected, for example integrally formed with the sealing section within the subsection that defines the sealing plane.

In particular, at least in a mounted state of the assembly in a gap between the at least two mating parts at least the sealing section of the gasket is arranged. In some advantageous embodiments at least one of the at least two mating parts has an overlapping section.

In particular, at least in a mounted state of the assembly, the overlapping section of one of the at least two mating parts at least partly overlaps with a section of the other of the at least two mating parts.

Preferably, at least in a mounted state of the assembly, the overlapping section of one of the at least two mating parts at least partly overlaps a gap between the at least two mating parts.

In particular, the overlapping section overlaps at least partly the gap in which at least in the mounted state the sealing section is arranged.

Advantageously, at least one contacting face of one group, in particular at least several contacting faces, for example all contacting faces, of one group, is/are configured for contacting the overlapping section of at least one mating part. In particular, at least in a mounted state this at least one contacting face, in particular these at least several, for example all, contacting faces, of one group is/are contacting this overlapping section preferably in an electrically conductive manner.

In some preferred embodiments, at least one contacting face, in particular at least one contacting face of the first group and/or at least one contacting face of the second group, preferably at least several, for example all, contacting faces of the first and/or second group, is/are arranged outside of the gap in which in particular in the mounted state the sealing section is arranged.

In particular, at least the contact segment, which provides the at least one contacting face that is arranged outside of the gap, is arranged outside of the gap.

In particular, a contact segment comprises a contacting portion that provides at least one contacting face. In particular, a contact segment comprises at least one connecting portion. The connecting portion in particular connects, for example fixedly, the contacting portion with another segment, preferably with at least one sealing segment, of the gasket. Preferably, the contacting portion and connecting portion of a contacting segment are integrally formed.

In particular, the connecting portion of at least one contact segment, for example of at least one contact segment of the first group and/or of at least one contact segment of the second group, extends away from the sealing section. In some preferred embodiments, the connecting portion extends at least partially at least approximately in the sealing direction away from the sealing section.

In some preferred embodiments the connecting portion of at least one contact segment of the first group and the connecting portion of at least one contact segment of the second group are extending at least approximately in a same oriented direction away from the sealing section.

In some preferred embodiments, the connecting portion of at least one contact segment of the first group and the connecting portion of at least one contact segment of the second group are extending away from the sealing section in at least approximately oppositely oriented directions.

In some advantageous embodiments, the connecting portion of at least one contact segment projects out of a gap between the two mating parts, in particular out of the gap in which the sealing section is arranged.

In some advantageous embodiments, at least one contacting face of at least one group, for example at least one contacting face of the first group and/or at least one contacting face of the second group, is in electrically conductive contact with an outer wall section face of the respective mating part. For example the respective at least one contacting face touches the respective outer wall section face. For example, this at least one contacting face is a radially inward facing face.

In some advantageous embodiments, at least one contacting face of at least one group, for example of the first and/or second group, is in electrically conductive contact with the overlapping section of at least one mating part. For example, this at least one contacting face is a radially outward directed face.

In some preferred embodiments at least one contacting face, preferably at least several, for example all, contacting faces, of the first group and at least one sealing face, preferably at least several, for example all, sealing faces, of the first group are facing at least approximately in a same direction.

In some preferred embodiments at least one contacting face, preferably at least several, preferably all, contacting faces, of the second group and at least one sealing face, preferably at least several, for example all, sealing faces, of the second group are facing at least approximately in a same direction.

In particular, herein above and subsequently directions are at least approximately similar when an angle between the two directions is at least approximately equal to or smaller than 20°, in particular equal to or smaller than 15°, in particular equal to or smaller than 10° and/or if a difference in the direction of the two directions is technically unavoidable and/or technically irrelevant.

For example, a direction, in particular the sealing direction and/or the axial direction of the sealing axis, in which at least one sealing face of the first group and at least one sealing face of the second group are facing but oppositely to each other, is at least approximately similar to a direction in which at least one contacting face of the first group and at least one contacting face of the second group are facing but oppositely to each other.

In some embodiments, at least one contacting face, in particular at least several, for example all, contacting faces of the first group and/or at least one contacting face, preferably at least several, for example all, contacting faces, of the second group is/are at least approximately facing in the radial direction of the sealing axis.

In some preferred embodiments, at least one contacting face, for example at least several contacting faces, is/are arranged in the gap in which the sealing section is arranged. In particular, the contacting faces arranged in the gap with the sealing section are facing at least approximately in the same direction than the sealing faces and/or are facing in the axial direction of the sealing axis.

With respect to the sealing section no further details have been given so far.

Preferably, the sealing section comprises at least one resilient element.

Advantageously, at least one resilient element of the sealing section provides at least one sealing face, in particular at least one sealing face of the first group and/or at least one sealing face of the second group.

For example, the resilient element comprises at least one sealing portion that provides a sealing face of the first group and/or at least one sealing portion that provides a sealing face of the second group.

For example, at least one resilient element of the sealing section has at least one hollow space.

In particular, at least one hollow space of the resilient element is located adjacent to a sealing portion of the resilient element and the sealing portion provides at least one sealing face.

In some advantageous embodiments, a hollow space of at least one resilient element is provided between a sealing portion that provides a sealing face of the first group and a sealing portion that provides a sealing face of the second group.

In particular, the hollow space is in the sealing direction adjacent to the sealing portion and/or the hollow space is with respect to the sealing direction between the two sealing portions.

For example, an advantage thereof is that the at least one resilient element can at least partly provide a sealing force for improving the sealing between the gasket and the mating part.

In particular, the at least one resilient element enables the sealing section to adapt to variations in a gap between the to be sealed faces of the at least two mating parts. For example, the variations may result from surface imperfections of the to be sealed faces. In particular, the variations result from varying thermal elongations and/or dynamic forces occurring within and/or acting on the assembly, in particular within and/or on the mating parts.

In particular, the hollow space provides for the sealing portion a void space enabling the sealing portion to adapt to the variations.

Advantageously, the gasket, in particular the sealing section, comprises at least one stopper structure. Preferably, the at least one stopper structure prevents a too strong deformation of the resilient part.

In particular, at least in an elasticity range the resilient part is at least essentially elastically deformable.

Advantageously, the at least one stopper structure allows only deformations of the resilient part within its elasticity range and/or prevents deformations of the resilient part out from the elasticity range.

For example, the stopper structure allows only deformations of the resilient part such that at least a fraction, in particular small fraction, of the hollow space remains.

In particular, the sealing section comprises at least one solid element.

In particular, within the solid element, there is material of the sealing section throughout between opposing face regions of the solid element, wherein in particular the opposing face regions are opposing each other with respect to the sealing direction.

In particular, the solid element provides stability to the sealing section.

Advantageously, at least one electrically conductive path runs through the solid element of the sealing section.

Preferably, at least a portion of the solid element and at least a portion, in particular at least a sealing portion, of the resilient part are built by a same sealing segment of the sealing section and/or are integrally formed.

In some preferred embodiments, the sealing section is formed by a single sealing segment.

In some preferred embodiments, aforementioned first segment and second segment are a same sealing segment, for example the single sealing segment.

In some advantageous embodiments, the sealing section is formed by at least two different sealing segments. For example, then aforementioned first segment and second segment are different sealing segments.

Advantageously, at least some, for example all, of the several sealing segments are electrically conductive connected to each other.

In particular, at least two of the several sealing segments, in particular the first and second segment, have an electrically conductive face and are preferably at the electrically conductive face in electrical contact with at least another sealing segment.

Preferably, at least two sealing segments, for example the first and second segment, lie at least with their electrically conductive face onto each other, for example within the solid element of the sealing section.

Advantageously, at least one sealing segment, preferably each of at least some, for example of all, of the sealing segments, is built by an electrically conductive material, in particular a metallic material, and/or is at least partly coated, in particular at least at a sealing face of its sealing portion coated, with the sealing material.

Preferably, at least one sealing segment its electrically conductive face and its sealing face are located on opposite surfaces of the sealing segment. For example, the sealing segment has a first surface providing the sealing face and the first surface is at least within the sealing face and for example at least essentially fully coated. In particular, the sealing segment has a second surface at which the electrically conducive face is located and preferably the second surface is not coated. In particular, the first and second surfaces are, in particular with respect to the sealing direction, opposite surfaces of the sealing segment.

In particular, the sealing section runs, in particular along its longitudinal extension, along a sealing contour and in particular in a closed manner around the sealing axis.

In particular, the sealing section runs at least partly within a sealing plane and the sealing plane extends at least approximately perpendicular to the sealing axis.

In some preferred embodiments the entire sealing section extends within a single sealing plane.

In other advantageous embodiments, the sealing section has several subsections which run in respective sealing planes on different levels along the axial direction of the sealing axis. In particular, then the several sealing planes are at least approximately parallel arranged to each other. In particular, then the sealing section has connecting subsections which connect two subsections of different sealing planes and the connecting subsections run oblique with respect to the axial direction of the sealing axis between at least two sealing planes.

In some advantageous embodiments, the gasket comprises at least one holding structure for holding the gasket, in particular at least in a mounted state, in place with respect to at least one of the two mating parts.

In particular, therewith a mounting of the gasket is simplified, because the gasket is held in place with respect to at least one of the two mating parts by the holding structure and the other of the at least two mating parts has to be assembled to the unit of the one mating part with the gasket.

For example, the holding structure holds the gasket during use in place although the assembly and in particular the mating parts are subject to different thermal elongations and/or dynamics forces.

Preferably, the holding structure comprises at least one clip element for engaging with at least one of the at least two mating parts.

Preferably, the holding structure is at least partly built by at least one holding segment, preferably by a plurality of holding segments. In particular, at least one holding segment builds a clip element.

Preferably, at least one holding segment is fixedly connected with and in particular integrally formed with a sealing segment of the sealing section.

Preferably, at least one clip element and/or at least one holding segment is resiliently arranged, in particular resiliently arranged with respect to the sealing section.

Advantageously, at least one clip element and/or at least one holding segment projects out of the sealing plane.

Preferably, at least one clip element and/or at least one holding segment is configured to engage the at least one mating part at a wall face which is located at a different surface of the mating part than the to be sealed face. For example, the surface for engagement and the surface with the to be sealed face meet each other at an edge section of the mating part.

In advantageous embodiments, the holding structure is at least partly built by at least one contact segment, in particular by at least one contact segment of the first group and/or at least one contact segment of the second group. In particular, then at least one contact segment and at least one holding segment are a same segment.

Further details regarding the gasket have not been provided so far.

In advantageous embodiments, the gasket comprises at least one layer.

In particular, the at least one layer forms at least one sealing segment, in particular the first sealing segment and/or the second sealing segment.

Preferably, at least one layer forms at least one contact segment, in particular at least one contact segment of the first group and/or at least one contact segment of the second group.

In some preferred embodiments, the gasket comprises exactly one layer.

In particular, the exactly one layer provides at least one sealing face, for example at least several, preferably all, sealing faces, of the first group and/or at least one sealing face, for example at least several, preferably all, sealing faces, of the second group.

Preferably, the exactly one layer provides at least one contacting face, in particular at least several, preferably all, contacting faces, of the first group and/or at least one contacting face, in particular at least several, preferably all, contacting faces, of the second group.

Preferably, the exactly one layer forms at least one sealing segment, in particular the first and/or second sealing segment, in particular all sealing segments.

In particular, the exactly one layer forms at least one contact segment, preferably at least several, for example all, of a plurality of contact segments, in particular at least one contact segment, preferably at least several, for example all, of a plurality of contact segments, of the first and/or second group.

In some advantageous embodiments the gasket comprises at least two layers, for example exactly two layers.

Preferably, at least two of the at least two layers form in each case at least one respective sealing segment and/or at least one contact segment.

Preferably, at least one layer, in particular at least one layer of the at least two layers, provide at least one sealing face, for example at least several, in particular all, sealing faces, of one group and at least one contacting face, preferably at least several, for example all, sealing faces, of the other group.

Advantageously, a first layer provides at least one sealing face, for example several, in particular all, sealing faces of the first group and at least one contacting face, preferably at least several, for example all, contacting faces, of the second group and/or a second layer provides at least one sealing face, for example several, in particular all, sealing faces, of the second group and at least one contacting face, preferably at least several, for example all, contacting faces, of the first group.

Preferably, at least one layer of the gasket provides at least one sealing face for one of the at least two mating parts and at least one contacting face for the other of the at least two mating parts.

In particular, at least one contacting face, preferably at least several, in particular all, contacting faces, of the first group are provided by one layer of the gasket, for example by a second layer, and at least one contacting face, preferably at least several, for example all, contacting faces, of the second group are provided by another layer of the gasket, for example by a first layer.

For example, at least one sealing face, for example several, in particular all, sealing faces, of the first group are provided by one layer of the gasket, for example by a first layer, and at least one sealing face, for example several, in particular all, sealing faces, of the second group are provided by another layer of the gasket, for example by a second layer.

In particular, the first layer and the second layer are different layers of the at least two layers.

Previously and subsequently the mentioning of a first and/or a second element, like for example first and second group and/or first and second segment and/or first and second layer has to be construed to only name one or another element, in particular one or another group and/or segment and/or layer. The mentioning of a first and second element implies neither a ranking of elements nor information about the number of the elements nor other implicit notions.

Preferably, at least one layer on one of two opposite surfaces of the at least one layer at least one sealing face is provided and on the other of the two opposite surfaces of the at least one layer at least one contacting face is provided.

In particular, an advantage thereof is that one of the two surfaces of the at least one layer can be prepared, preferably optimized, for the sealing function, for example be coated, and the other surface can be prepared, preferably optimized, for the electrically contacting function, for example be machined for a good electrically conductivity and/or kept metallic for the electrical conductivity.

In particular, at least one layer, in particular the at least two layers, for example the first and/or second layer, are built at least essentially by a metallic material.

For example, the metallic material comprises and/or is steel, for example spring steel.

For example, therewith at least a body of the layer is electrically conductive and/or can provide stability and resilience, for example a spring like behavior.

Preferably, at least one layer is at least partially coated with a sealing material, preferably a sealing material as described above, on one surface that in particular provides at least one sealing face. In particular, on one surface, in particular the other surface, at least one layer is not coated, and in particular at the uncoated surface at least one contacting face is provided.

Preferably, at least one layer of the gasket, for example the first and/or second layer, is on one of its surfaces at least essentially fully coated.

For example, an advantage thereof is that the production of the gasket, in particular of its at least one layer, is simplified, because the at least one layer can be fully coated on one of its surfaces, but due to the contacting faces, one of which is preferably provided on the opposite side of the coated surface, still an electrical contact with the mating parts can be provided.

In particular, at least two layers of the gasket are electrically connected to each other.

In particular, at least one layer providing at least one contacting face of the first group and at least one other layer providing at least one contacting face of the second group are electrically connected to each other, for example directly or indirectly, preferably through another layer, electrically connected to each other.

In particular, therewith an electrical path through the layers connecting at least one contacting face of the first group and at least one contacting face of the second group is provided.

Preferably, at least two layers lie at least partially on top of each other.

In particular, at least two layers lie at least partially with electrically conductive faces onto each other, such that advantageously in a simple manner they are electrically connected to each other. Preferably, at least one layer its electrically conductive face is provided on the same surface than at least one contacting face, such that advantageously only this one surface has to be prepared, for example optimized, for electrical conductivity.

In particular, at least the portions with which at least two layers lie on each other build the solid element of the gasket.

In particular, at least two layers lie at least partly within the sealing section on each other.

In advantageous embodiments at least one layer of the gasket, for example at least two layers of the gasket, in particular the first and/or second layer, form/forms at least partly the resilient element of the sealing section. In particular, at least one portion of at least one layer builds at least partly the resilient element.

Preferably, at least one layer comprises a bead for at least partly forming the resilient element.

Further details regarding the assembly have not been provided so far.

In particular, the assembly is an electrical assembly.

In particular for electrical assemblies the provided solutions have particular advantages for example for sealing the interior reliably against fluids and/or other environmental conditions and thereby preventing damages to electro-technical elements in an interior of the assembly.

In particular, due to the conductivity function of the gasket electrostatic charges and/or other voltage issues with the to be sealed mating parts can be avoided. For example, an electromagnetic compatibility of the assembly is improved.

For example, the assembly is an automotive assembly.

In particular, for automotive assemblies the provided solutions have particular advantages. In particular, automotive assemblies are exposed to various, for example at least partly aggressive mediums and/or conditions and therefore a reliable sealing is important. For example, for automotive assemblies, the conductivity function of the gasket is of importance too, for example for the reason as described before.

The at least two mating parts, for example at least the first and second mating parts, are different parts.

In particular, the at least two mating parts are parts of a housing.

In some embodiments, the at least two mating parts, in particular at least the first and second mating parts, are different parts of a single piece component.

In other embodiments, the at least two mating parts, in particular at least the first and second mating parts, are at least parts of different pieces.

Features and/or elements described herein to be provided for example and/or in particular and/or advantageously and/or preferably and/or in a variant and/or the like, are optional features and/or elements which for example provide inventive improvements but are not necessarily essential for the underlying inventive idea.

The solutions in accordance with the present invention comprise, in particular, the combinations of features defined by the following embodiments numbered consecutively.
1. Gasket (120), in particular gasket (120) for an electrical assembly and/or an automotive assembly, for sealing between at least two mating parts (112, 114), wherein the gasket (120) comprises a sealing section (212) and at least one electrically connecting unit (252), wherein the sealing section (212) comprises a first group of at least one sealing face (216, 218) for one of the at least two mating parts (112, 114) and a second group of at least one sealing face (216, 218) for the other of the at least two mating parts (112, 114) and wherein the at least one electrically connecting unit (252) comprises a first group of at least one electrically conductive contacting face (264) for the one of the two mating parts (112, 114) and a second group of at least one electrically conductive contacting face (264) for the other of the at least two mating parts (112, 114), wherein at least one sealing face (216, 218) of the first group and at least one electrically conductive contacting face (264) of the first group are different faces and/or at least one sealing face (216, 218) of the second group and at least one electrically conductive contacting face (264) of the second group are different faces.
2. Use of a gasket (120) for sealing between at least two mating parts (112, 114) and electrically connecting the at least two mating parts (112, 114), wherein the gasket (120) comprises a sealing section (212) for sealing between the at least two mating parts (112, 114) and at least one electrically connecting unit (252) for electrically connecting the at least two mating parts (112, 114), wherein the sealing section (212) comprises a first group of at least one sealing face (216, 218) for one of the two mating parts (112, 114) and a second group of at least one sealing face (216, 218) for the other of the at least two mating parts (112, 114) and wherein in use the at least one sealing face (216, 218) of the first group is arranged in a sealed manner with the one of the at least two mating parts (112, 114) and the at least one sealing face (216, 218) of the second group is arranged in a sealed manner with the other of the at least two mating parts (112, 114) and wherein the electrically connecting unit (252) comprises a first group of at least one electrically conductive contacting face (264) for one of the two mating parts (112, 114) and a second group of at least one electrically conductive contacting face (264) for the other of the at least two mating parts (112, 114) and wherein in use the at least one electrically conductive contacting face (264) of the first group is arranged in electrically conductive contact with the one of the at least two mating parts (112, 114) and the at least one electrically conductive contacting face (264) of the second group is arranged in an electrically conductive contact with the other of the at least two mating parts (112, 114) and wherein at least one sealing face (216, 218) of the first group and at least one electrically conductive contacting face (264) of the first group are different faces and/or at least one sealing face (216, 218) of the second group and at least one electrically conductive contacting face (264) of the second group are different faces.
3. Assembly (100), in particular an electrical assembly and/or an automotive assembly, comprising at least two mating parts (112, 114) and a gasket (120) in accordance with embodiment 1, wherein at least one sealing face (216, 218) of the first group is in sealing arrangement with one of the at least two mating parts (112, 114) and at least one sealing face (216, 218) of the second group is in sealing arrangement with the other of the at least two mating parts (112, 114) and wherein at least one electrically conductive contacting face (264) of the first group is in electrically conductive contact with the one of the at least two mating parts (112, 114) and at least one electrically conductive contacting face (264) of the second group is in electrically conductive contact with the other of the at least two mating parts (112, 114).
4. Gasket (120) according to embodiment 1 and/or use according to embodiment 2 and/or assembly (100) according to embodiment 3, wherein at least one sealing face (216, 218) of the first group is coated with a sealing material and/or at least one sealing face (216, 218) of the second group is coated with a sealing material.
5. Gasket (120) and/or use and/or assembly (100) according to the preceding embodiment, wherein the sealing material comprises an elastomer, in particular comprises a natural and/or synthetic rubber.
6. Gasket (120) and/or use and/or assembly (100) according to one of the preceding embodiments, wherein at least one contacting face (264) of the first group and/or at least one contacting face (264) of the second group is made of an electrically conductive material and/or is in particular a metallic face.
7. Gasket (120) and/or use and/or assembly (100) according to one of the preceding embodiments, wherein at least one contacting face (264) is a curved face.
8. Gasket (120) and/or use and/or assembly (100) according to one of the preceding embodiments, wherein within the gasket (120) there is at least one electrically conductive path (266) between at least one contacting face (264) of the first group and at least one contacting face (264) of the second group, wherein in particular each contacting face (264) of each of the first and second group is electrically connected with at least one contacting face (264) of the other group by an electrically conductive path (266).
9. Gasket (120) and/or use and/or assembly (100) according to one of the preceding embodiments, wherein at least one electrically conductive path (266) runs at least partially through the sealing section (212).
10. Gasket (120) and/or use and/or assembly (100) according to one of the preceding embodiments, wherein at least one contact segment (254) that provides at least one contacting face (264) is fixedly connected with the sealing section (212).
11. Gasket (120) and/or use and/or assembly (100) according to one of the preceding embodiments, wherein at least one contact segment (254) that provides at least one contacting face (264) for one of the at least two mating parts (112, 114) is fixedly connected with a sealing segment of the sealing section (212), that sealing segment provides at least one sealing face (216, 218) for the other of the at least two mating parts.
12. Gasket (120) and/or use and/or assembly (100) according to one of the preceding embodiments, wherein at least one contact segment (254) that provides at least one contacting face (264) is integrally formed with at least a segment of the sealing section (212).
13. Gasket (120) and/or use and/or assembly (100) according to one of the preceding embodiments, wherein at least one contact segment (254) that provides at least one contacting face (264) for one of the at least two mating parts (112, 114) is integrally formed with a sealing segment of the sealing section (216, 218), that sealing segment provides at least one sealing face (216, 218) for the other of the at least two mating parts (112, 114).
14. Gasket (120) and/or use and/or assembly (100) according to one of the preceding embodiments, wherein the contacting faces (264) of the connecting unit (252) are arranged along the sealing section (212) with an offset to each other.
15. Gasket (120) and/or use and/or assembly (100) according to one of the preceding embodiments, wherein at least one contact segment (254), that provides at least one contacting face (264), is resiliently arranged, in particular with respect to the sealing section (212) resiliently arranged.
16. Gasket (120) and/or use and/or assembly (100) according to one of the preceding embodiments, wherein at least one contact segment (254) that provides at least one contacting face (264) of the first group and at least one contact segment (254) that provides at least one contacting face (264) of the second group are resiliently arranged with respect to each other.
17. Gasket (120) and/or use and/or assembly (100) according to one of the preceding embodiments, wherein at least one contacting face (264) of the first group and at least one sealing face (216, 218) of the first group are facing in different directions and/or wherein at least one contacting face (264) of the second group and at least one sealing face (216, 218) of the second group are facing in different directions.
18. Gasket (120) and/or use and/or assembly (100) according to one of the preceding embodiments, wherein at least one contacting face (264) is arranged outside of a sealing plane (292), wherein in particular the sealing plane (292) is defined by at least a subsection of the sealing section (292).
19. Gasket (120) and/or use and/or assembly (100) according to one of the preceding embodiments, wherein at least one contacting face (264) of the gasket (120) is at least configured for contacting an overlapping section (182) of one mating part (112, 114), wherein in particular the overlapping section (182) at least partly overlaps with a section of the other mating part and/or at least partly overlaps a gap (176) between the at least two mating parts (112, 114).
20. Gasket (120) and/or use and/or assembly (100) according to one of the preceding embodiments, wherein at least one contacting face (264) of the first group and at least one sealing face (216, 218) of the first group are facing in at least approximately the same direction and/or wherein at least one contacting face (264) of the second group and at least one sealing face (216, 218) of the second group are facing in at least approximately the same direction.
21. Gasket (120) and/or use and/or assembly (100) according to one of the preceding embodiments, wherein the sealing section (212) comprises at least one resilient element (232).
22. Gasket (120) and/or use and/or assembly (100) according to one of the preceding embodiments, wherein at least one resilient element (232) of the sealing section (212) provides at least one sealing face (216, 218), in particular at least one sealing face (216, 218) of the first group and/or at least one sealing face (216, 218) of the second group.
23. Gasket (120) and/or use and/or assembly (100) according to one of the preceding embodiments, wherein at least one resilient element (232) of the sealing section (212) has at least one hollow space (228) adjacent to a sealing portion (222, 224) of the resilient element (232), wherein that sealing portion (222, 224) provides at least one sealing face (216, 218).
24. Gasket (120) and/or use and/or assembly (100) according to one of the preceding embodiments, wherein at least one resilient element (232) of the sealing section (212) has a hollow space (228) between a sealing portion (222, 224) of the resilient element (232), that sealing portion (222, 224) provides a sealing face (216, 218) of the first group, and a sealing portion (222, 224) of the resilient element (232), that sealing portion (222, 224) provides a sealing face (216, 218) of the second group.
25. Gasket (120) and/or use and/or assembly (100) according to one of the preceding embodiments, wherein the gasket (120), in particular its sealing section (212), comprises at least one stopper structure (242) which in particular prevents a too strong deformation of the resilient element (232).
26. Gasket (120) and/or use and/or assembly (100) according to one of the preceding embodiments, wherein the sealing section (212) comprises at least one solid element (236), wherein in particular within the solid element (236) there is material of the sealing section (216, 218) throughout between opposing face regions of the solid element (236).
27. Gasket (120) and/or use and/or assembly (100) according to one of the preceding embodiments, wherein the gasket (120) comprises at least one holding structure (228) for holding the gasket (120) in place with respect to at least one of the two mating parts.
28. Gasket (120) and/or use and/or assembly (100) according to one of the preceding embodiments, wherein the holding structure (228) is built at least partly by at least one contact segment (254) of the connecting unit (252).
29. Gasket (120) and/or use and/or assembly (100) according to one of the preceding embodiments, wherein the gasket (120) comprises at least one layer (312, 314).
30. Gasket (120) and/or use and/or assembly (100) according to one of the preceding embodiments, wherein the gasket (120) comprises at least two layers (312, 314).
31. Gasket (120) and/or use and/or assembly (100) according to one of the preceding embodiments, wherein at least one layer (312, 314) of the gasket (120) provides at least one sealing face (216, 218) for one of the at least two mating parts (112, 114) and at least one contacting face (264) for the other of the at least two mating parts (112, 114).
32. Gasket (120) and/or use and/or assembly (100) according to one of the preceding embodiments, wherein at least one sealing face (216, 218) of the first group and/or at least one contacting face (264) of the second group is/are provided by one layer (312, 314) of the gasket (120) and at least one sealing face (216, 218) of the second group and/or at least one contacting face (264) of the first group is/are provided by another layer (312, 314) of the gasket (120).
33. Gasket (120) and/or use and/or assembly (100) according to one of the preceding embodiments, wherein at least one layer (312, 314) on one of two opposite surfaces (316, 317, 318, 319) of that at least one layer (312, 314) at least one sealing face (216, 218) is provided and on the other of the two opposite surfaces (316, 317, 318, 319) of that at least one layer (312, 314) at least one contacting face (264) is provided.
34. Gasket (120) and/or use and/or assembly (100) according to one of the preceding embodiments, wherein at least one layer of the gasket (120) is on one of its surfaces (316, 317, 318, 319) at least essentially fully coated.
35. Gasket (120) and/or use and/or assembly (100) according to one of the preceding embodiments, wherein at least two layers (312, 314) of the gasket (120) are electrically connected to each other.
36. Gasket (120) and/or use and/or assembly (100) according to one of the preceding embodiments, wherein at least two layers (312, 314) of the gasket (120) lie at least partly on each other, in particular lie with electrically conductive faces on each other and/or their portions lying on each other build at least partly the solid element (236) of the gasket (120).
37. Gasket (120) and/or use and/or assembly (100) according to one of the preceding embodiments, wherein at least one layer (312, 314) of the gasket (120), in particular at least two layers (312, 314) of the gasket (120) forms/form at least partly the resilient element (232) of the sealing section (212).

Other aspects, objectives and advantages of the invention will become more apparent from the following detailed description when taken in conjunction with the accompanying drawings.

In the drawings:
- fig. 1: shows a sectional depiction of an assembly with a gasket between two mating parts;
- fig. 2: shows a perspective view on the gasket;
- fig. 3: shows a partially enlarged view of the sectional depiction of fig. 1 in the area of a sealing section of the gasket;
- fig. 4: shows a partially enlarged view of the sectional depiction of fig. 1 in the area of a contacting unit of the gasket;
- fig. 5: shows an exploded view of the gasket;
- fig. 6: shows a sectional depiction of the gasket according to the section VI-VI shown in fig. 2;
- fig. 7: shows a sectional depiction of the gasket according to the section VII-VII shown in fig. 2;
- fig. 8: shows a sectional depiction similar to the one of fig. 1 of another embodiment;
- fig. 9: shows a partial perspective view on a gasket of another exemplary embodiment;
- fig. 10: shows a sectional depiction according to the section X-X shown in fig. 9 of the gasket between two mating parts;
- fig. 11: shows a partial perspective view on a gasket of yet another embodiment;
- fig. 12: shows a sectional depiction according to the section XII-XII shown in fig. 11 of the gasket between two mating parts;
- fig. 13: shows a partial perspective view on a gasket of yet another embodiment; and
- fig. 14: shows a sectional depiction of the section XIV-XIV shown in fig. 13 of the gasket between two mating parts.
- fig. 15: shows a sectional depiction similar to the one of fig. 1 of yet another embodiment.

An assembly 100 of an exemplary embodiment comprises at least two mating parts 112 and 114 and a gasket 120 for sealing between the two mating parts 112 and 114.

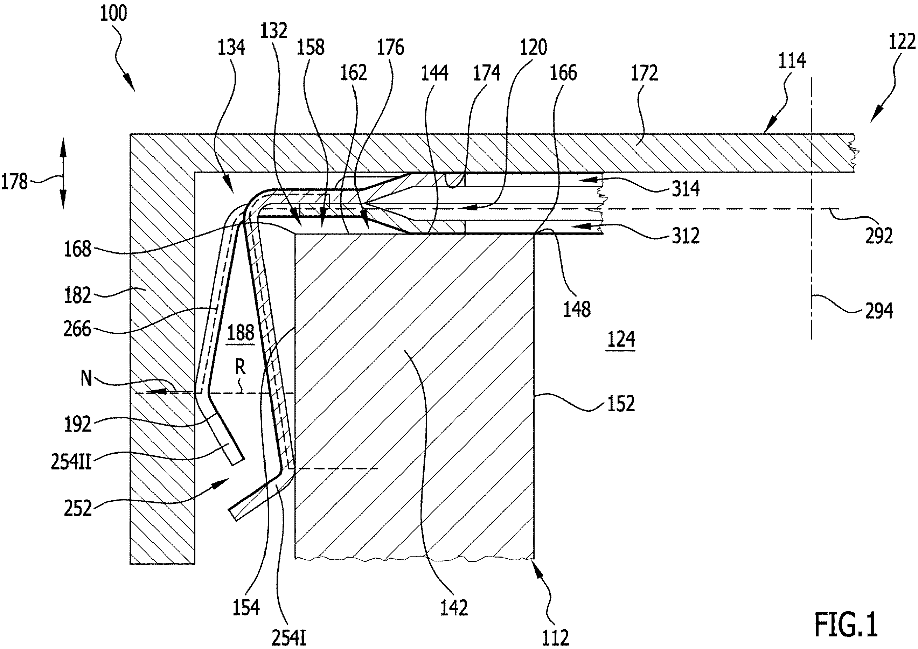

Exemplarily, a partial sectional depiction of the assembly 100 is shown in fig. 1.

In particular, the assembly 100 is an assembly of an automotive component.

In particular, the assembly 100 is at least part of an electro-technical apparatus.

In particular, the mating parts 112, 114 are housing parts of a housing 122 of the assembly 100.

In particular, the parts of the housing 122 surround an interior 124 of the housing 122.

In particular, the interior 124 is a receptacle for exactly one or more electrical devices, which are not shown explicitly in the figures. For example, at least one electrical device comprises electrical circuits and/or a battery and/or a drive unit, in particular a drive unit for a car.

In some variants the housing 122 is built by only the two mating parts 112 and 114. In other variants the housing 122 comprises the two mating parts 112, 114 and other housing parts.

The two mating parts 112 and 114 face each other with respective joining sides 132 and 134.

The mating part 112 comprises an outer wall 142 that at least partially surround the interior 124.

At the joining side 132 the outer wall 142 has a to be sealed face 144 that faces towards the other mating part 114. For example, the portion of the outer wall 142 with the to be sealed face 144 runs in a closed manner around a housing opening 148 and the to be sealed face 144 frames the housing opening 148.

In particular, the outer wall 142 has an inner wall section face 152 which faces towards the interior 124 and at least partially delimits the interior 118. The outer wall 142 has opposite to the inner wall section face 152 an outer wall section face 154.

The inner wall section face 152 and the outer wall section face 154 run to a front side 158 of the outer wall 142 and in particular at an end surface 162 of the front side 158 the to be sealed face 144 of the mating part 112 is located.

In particular, the inner wall section face 152 and the end surface 162 meet at an inner edge section 166 and the outer wall section face 154 and the end surface 162 meet at an outer edge section 168. In particular, the end surface 162 extends between the inner and outer edge sections 146 and 168. Preferably, the inner and outer wall section faces 152, 154 run away from the end surface 162 from the respective edge section 166, 168.

In some variants, the mating part 112 has further openings at which for example further housing parts can be arranged and/or through which parts of an electro-technical apparatus, for example cables, can be passed. In particular, the electro-technical apparatus can be connected to other functional elements by these parts and is connected in a connected state. In other variants of the exemplary embodiment, it is provided that the mating part 112 with its outer wall 142 and other walls, if applicable, substantially surrounds the interior 124 in a closed manner and the mating part 112 has only the single housing opening 148.

The other mating part 114 comprises also an outer wall 172. At the joining side 134 of the mating part 114 the outer wall 172 has a to be sealed face 174 which faces in a sealing direction 178 to the to be sealed face 144 of the mating part 112.

In particular, there is a gap 176 between the to be sealed faces 144 and 174 of the two mating parts 112, 114.

Preferably, the mating part 114 has an additional wall section 182 that is formed to the outer wall 172. In particular, the wall section 182 extends from the outer wall 172 of the mating part 114 in a direction towards the other mating part 112 and partially overlaps in particular transverse to the sealing direction 178 at least partially with the outer wall 142 of the mating part 112 and/or with the gap 176.

In an overlapping area 192, in which the wall section 182 overlaps with the outer wall 142 of the mating part 112, a free space 188 is provided between the two mating parts 112, 114.

Advantageously, as an overlapping section the wall section 182 covers the gap 176 and provides additional protection.

The gasket 120 has a sealing section 212 for sealing between the two mating parts 112, 114 at their respective to be sealed faces 144, 174.

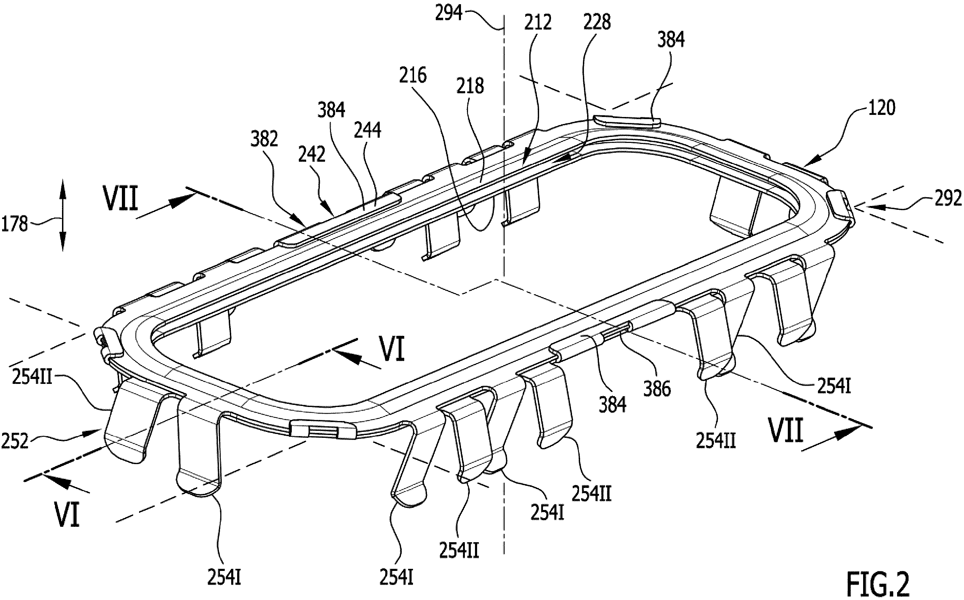

Exemplarily, the gasket 120 is shown in more details in figs. 2 to 7.

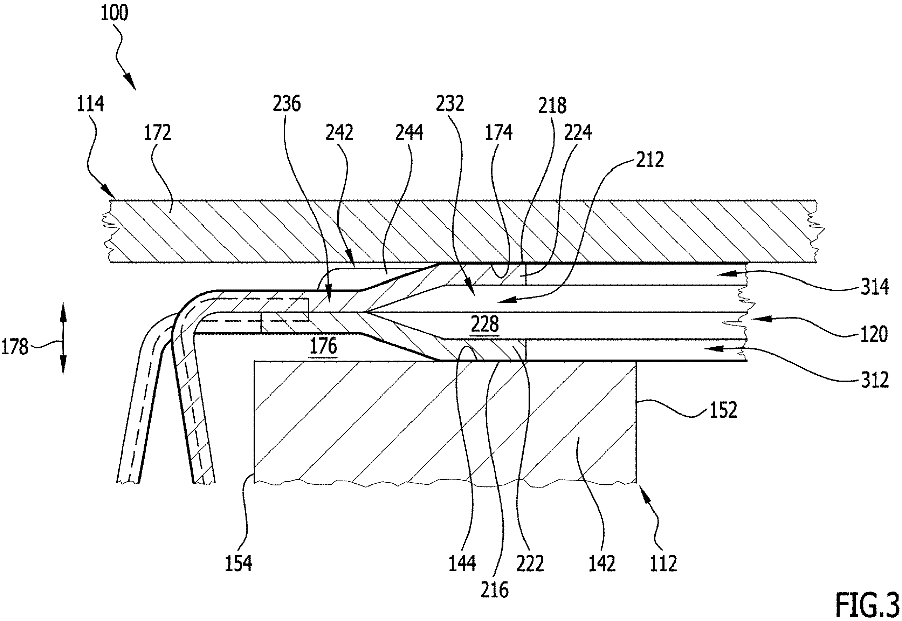

At the sealing section 212, the gasket 120 has two respective sealing faces 216 and 218, which are in a mounted state in sealing contact with the respective to be sealed face 144 and 174 of the mating parts 112 and 114, as exemplarily shown in fig. 3.

Advantageously, at least one of the sealing faces 216, 218, preferably each of the sealing faces 216, 218, is coated with a sealing material. In particular, the sealing material is a soft sealing material, which for example comprises or is an elastomer.

The gasket 120 has a sealing portion 222 which provides the sealing face 216 and a sealing portion 224 which provides the sealing face 218.

Preferably, a hollow space 228 is provided between the two sealing portions 222, 224, in particular in between with respect to the sealing direction 178.

Advantageously, the two sealing portions 222, 224 are flexibly arranged with respect to each other in a resilient element 232 of the sealing section 212.

Typically, the sealing section 212 comprises a solid element 236.

In particular, in the solid element 236 there is material of the sealing section 212 throughout between opposite surface regions of the solid element 236. The opposite surface regions of the solid element 236 face in particular in opposite directions with respect to the sealing direction 178 and/or in particular towards a respective mating part of the two mating parts 112, 114.

Preferably, the solid element 136 and the resilient element 232 are fixedly and/or directly connected to each other.

In particular, at least a portion of the solid element 136 is integrally formed with at least one sealing portion 222, 224.

Preferably, the gasket 120 has within the sealing section 212 a stopper structure 242. The stopper structure 242 is designed to prevent a too strong deformation of the resilient portion 232. Preferably, the stopper structure 242 is designed to prevent at least essentially a plastic deformation of the resilient portion 232. Preferably, the stopper structure 242 allows only a deformation of the resilient portion 232 within a tolerable regime and for example within the tolerable regime the resilient portion 232 is at least essentially elastically deformable.

For example, the stopper structure 242 comprises several stopper portions 244 in the sealing section 212, in particular within the solid element 236.

In particular, the stopper portions 244 are solid and have a thickness with respect to the sealing direction 178. The thickness of the stopper portions 244 is such to prevent a too strong deformation of the resilient portion 232 in the sealing direction 178, in particular such to allow a deformation of the resilient portion 232 in the sealing direction 178 but only in the tolerable regime.

For example, the thickness of the stopper portions 244 is larger than the sum of the thicknesses of the two sealing portions 222, 224, with their thicknesses being measured in the sealing direction 178. In particular, the thickness of the stopper portions 244 is smaller than the sum of the thicknesses of the sealing portions 222, 224 and the extent of the hollow space 228 in the sealing direction 178 between the two sealing elements 222, 224 when no force is applied to the sealing section 212 and the resilient element 232 is not deformed.

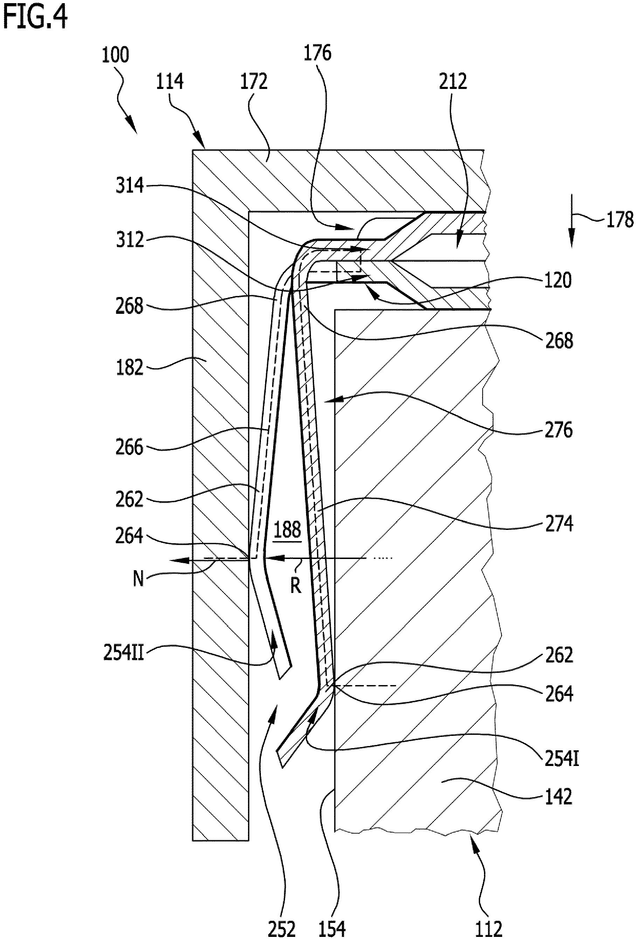

The gasket 120 comprises at least one electrically connecting unit 252 for electrically connecting the two mating parts 112, 114, as exemplarily shown in fig. 4.

The electrically connecting unit 252 comprises a first group of contact segments 254I for electrically contacting the one mating part 112 and a second group of contact segments 254II for electrically contacting the other mating part 114.

As far as the contact segments 254I,II of the two groups are built at least essentially in the same manner and/or have at least essentially the same features they are described in this application together and it is referred to the contact segments 254.

Each contact segment 254 has at a contacting portion 262 a contacting surface 264 for electrically contacting the respective mating part 112, 114. In particular, the contacting portion 262 and the contacting surface 264 are electrically conductive and made from an in particular good electrically conductive material, in particular from a metallic material.

In particular, the contacting face 264 is a metallic face.

Preferably, the contacting face 264 is a curved face. In particular, the contacting face 264 is curved along its extent and a radius R. of curvature is aligned transverse to the lateral extent of the contacting face 264 and/or at least approximately aligned in the direction of a normal N of the contacting face 264.

Preferably, the contacting portion 262 has a protruding contacting region, which provides the curved contacting face 264.

Typically, the contact segment 254 is connected to the sealing section 212, preferably fixedly connected to the sealing section 212. Preferably, the contact segment 254 is connected, in particular fixedly connected, to the solid portion 236.

In particular, each of the contact segments 254I,II of one group is connected by an electrically conductive path 266 to at least one contact segment 254I,II of the other group.

In particular, the electrically conductive path 266 runs through the sealing section 212 and preferably through its solid portion 236. For example, through the connection to the sealing section 212 at least most of the contact segments 254I,II of both groups are electrically connected to each other.

Advantageously, at least a pair of contact segments 254I,II of a contact segment 254I of the first group and of a contact segment 254II of the second group are resiliently arranged with respect to each other. Preferably, at least several contact segments 254 are resiliently arranged with respect to the sealing section 212 and in particular are resiliently connected to the sealing section 212.

For example, the contact segment 254 comprises a connecting portion 268 with which the contacting portion 262 of the contact segment 254 is connected to another part of the gasket 120, in particular to the sealing section 212. Advantageously, the connecting portion 268 is at least partially resiliently preformed.

In particular, the contact segment 254 extends, for example at least roughly in direction of the sealing direction 178, away from the sealing section 212.

In particular, the contacting face 264 of the contact segment 254 faces in a different direction than the sealing faces 216, 218. In particular, the different directions in which these faces are facing differ by at most 20 degrees and are for example at least approximately perpendicular to each other.

Preferably, the gasket 120 comprises several clip elements 274 of a holding structure 276.

The holding structure 276 is configured to hold the gasket 120 at least approximately in place with respect to at least one of the two mating parts 112, 114 in particular at least in a preassembled state and/or in a mounted state.

In particular, the clip elements 274 project, in particular at least approximately in the sealing direction 178, away from the sealing section 212.

For example, at least some of the clip elements 274 are resiliently arranged and/or resiliently built.

In preferred variants of this exemplary embodiment the clip elements 274 are built by at least several of the contact segments 254I of one of the two groups.

For example, the sealing section 212 runs at least essentially within a geometrical sealing plane 292. In particular, the sealing section 212 runs in a closed manner around a sealing axis 294. Conveniently, the sealing axis 294 is at least approximately perpendicular arranged to the sealing plane 292.

Preferably, the sealing direction 178 is arranged transverse to the sealing plane 292, in particular at least approximately perpendicular to the sealing plane 292. Preferably, the sealing direction 178 is arranged at least approximately in the same direction than the axial direction of the sealing axis 294.

In particular, the sealing faces 216, 218 extend at least approximately parallel to the sealing plane 192 and/or face at least approximately in the axial direction of the sealing axis 294.

Preferably, the contacting faces 264 face transverse to the axial direction of the sealing axis 294, advantageously they face at least approximately in the radial direction of the sealing axis 294.

In particular, the clip elements 274 project transverse to the geometrical sealing plane 292 and/or project for example at least approximately in the axial direction of the sealing axis 294.

Preferably, the gasket 120 comprises several layers 312, 314, for example exactly two layers 312, 314. In particular, the gasket 120 is built by the layers 312, 314.

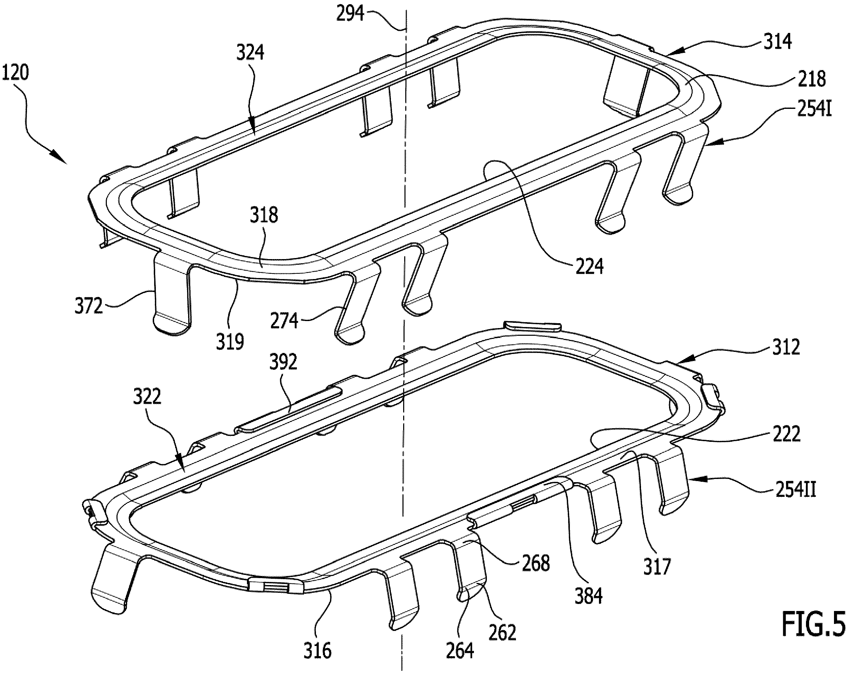

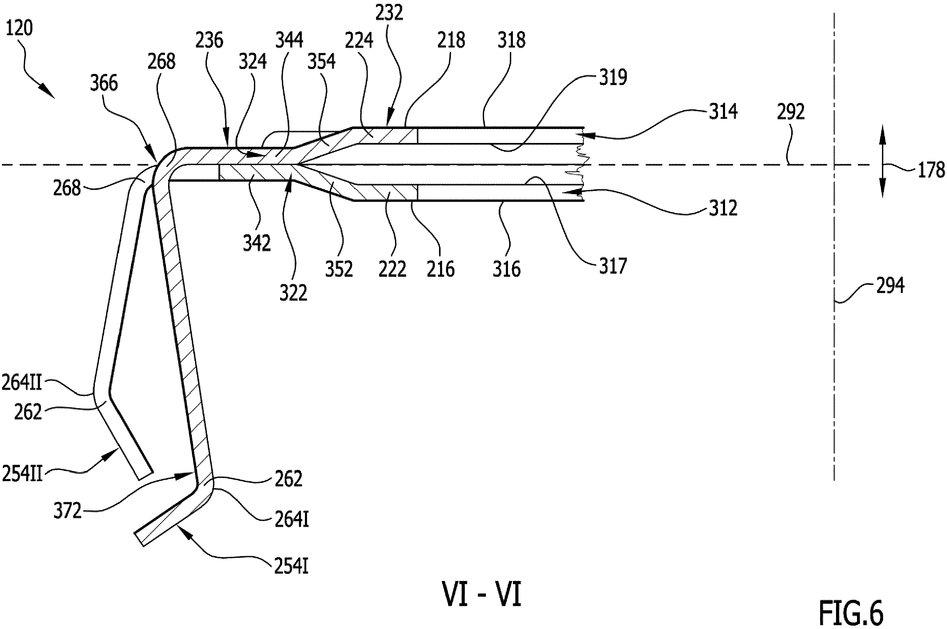

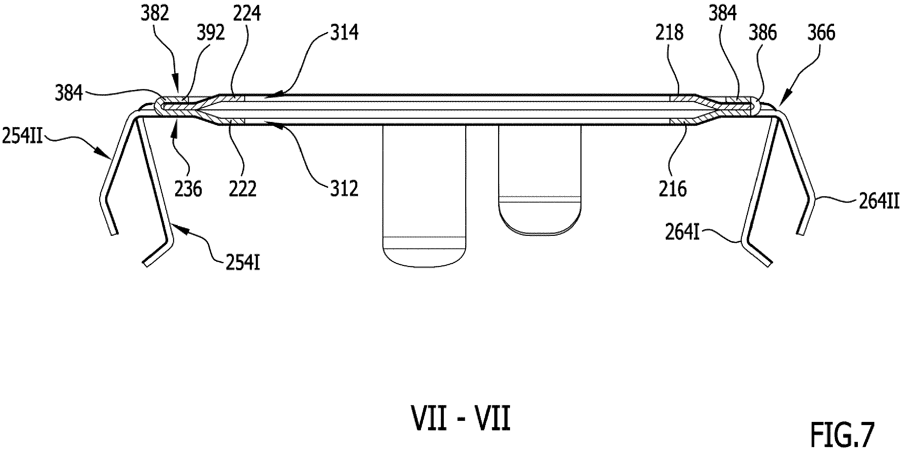

Exemplarily, the layers 312, 314 as mounted together to the gasket 120 are shown in fig. 2 and are shown separately in fig. 5. Exemplarily, sectional depictions of the layers are shown in figs. 6 and 7.

As far as the layers 312, 314 are at least essentially built the same and/or have at least essentially the same feature they are described in this application together.

In particular, each layer 312, 314 has two opposite surfaces 316, 317 and 318, 319. In particular, the surfaces 316, 317, 318, 319 of the layers 312, 314 are laterally extending surfaces at least in a state before the layers 312, 314 are formed and shaped for the gasket 120.

In particular, the layer 312, 314 has a much larger extent in the direction in which its surfaces 316, 317, 318, 319 are extending than in the direction normal to its surfaces 316, 317, 318, 319. In particular, a thickness of the respective layer 312, 314 is measured between the opposite surfaces 316, 317, 318, 319 and the thickness is smaller, in particular much smaller, than the extent of the surfaces 316, 317, 318, 319.

Each layer 312, 314 has a respective sealing segment 322, 324 and the sealing segment 322, 324 of the several layers 312, 314 build the sealing section 212.

In particular, the sealing segment 322 of one layer 312 forms one sealing portion 222 and the sealing segment 324 of another layer 314 forms another sealing portion 224.

Preferably, each of the sealing segments 322, 324 comprises a respective attaching portion 342, 344 and the respective attaching portions 342, 344 are attached to each other, in particular lie in direct contact onto each other.

In particular, the electrical path 266 runs through the attaching portions 342, 344.

In particular, the attaching portions 342, 344 built in such a way the solid element 236.

Preferably, the sealing portion 222, 224 and the attaching portion 342, 344 of a respective sealing segment 322, 324 are joined to each other by respective bridging portion 352, 354.

Advantageously, the bridging portion 352, 354 extends obliquely away from the respective attaching portion 342, 344 towards the respective sealing portion 222, 224, wherein a distance between the bridging portions 352 and 354 of the two layers 312, 314 increases with increasing distance to the respective attaching portion 342, 344. In particular, the distance between the bridging portions 352 and 354 is the smallest, for example there is essentially no distance, at the transition from the respective attaching portion 342, 344 to the bridging portion 352, 354 and the distance is the largest at the transition from the bridging portion 352, 354 to the respective sealing portion 222, 224. In particular, the distance between the bridging portions 352, 354 is measured at least approximately in the sealing direction 178 and/or transverse to the sealing plane 292.

The sealing portions 222, 224 of the two layers 312, 314 are distanced to each other in particular with respect to the sealing direction 178 and/or transverse to the geometrical sealing plane 292. Therewith, the hollow space 228 is formed between the sealing portions 222, 224.

Preferably, in such a manner, the sealing portions 222, 224 in particular together with the bridging portions 352, 354 build the resilient element 232 of the sealing section 212.

Preferably, the sealing segments 322, 324 comprise a bead, which in particular is built by the respective attaching portion 342, 344 and sealing portion 222, 224 and in particular the respective bridging portion 352, 354.

In some variants of the embodiment, the transition from the bridging portion 352, 354 to the respective sealing portion 222, 224 and/or the transition from the bridging portion 352, 354 to the respective attaching portion 342, 344 is edge like, like exemplarily shown in fig. 6.

In some variants the bridging portion 352, 354 is along its extent from the respective attaching portion 342, 344 to the respective sealing portion 222, 224 curved.

Different variants of the portions 222, 224, 342, 344, 352, 354 of the respective sealing segment 322, 324 and/or of the bead of the respective sealing segment 322, 324 are described later on in connection with other exemplary embodiments but these designs can also be incorporated in this embodiment.

In particular, the layers 312, 314 are coated at least at the sealing faces 216, 218 and preferably are coated at least on a side of their sealing segment 322, 324 at which the sealing face 216, 218 is located.

In particular, the respective layers 312, 314 are fully coated on the respective surface 316, 318 on which the respective sealing face 216, 218 is located. For example, the surface 316 of the layer 312 and the surface 318 of the layer 314 are fully coated.

In particular, the layers 312, 314 are at least partially coated with the sealing material as described above.

Preferably, the material of the layers 312, 314 at least comprises a metal and preferably is a metallic material.

Preferably, the opposite surface 317, 319 of the at least partially coated surface 316, 318 of the respective layers 312 and 314 is not coated. Advantageously, the opposite surface 317, 319 is an electrically conductive surface and/or preferably a metallic surface. Conveniently, the contacting faces 264 of the layer 312, 314 are located at the not coated surface 317, 319 of that layer 312, 314.

Advantageously, the layers 312, 314 are in contact with their respective attaching portions 342, 344 at their uncoated surfaces 317, 319 and are therefore electrically connected to each other.

In particular, the layers 312 and 314 form the contact segments 254. The contact segments 254 of a layer 312, 314 extend away from the respective sealing segment 322, 324 of that layer 312, 314.

In particular, the contact segment 254 is at least in a bent sector of its connecting portion 268 bent such that the contacting face 264 provided by this contact segment 254 faces to the other mating part 112, 114 than the sealing face 216, 218 of the sealing segment 322, 324 of the same layer 312, 314.

In particular, by this bending the contact segment 254 is at least in the bent sector resiliently formed and arranged to the respective sealing segment 322, 324.

Preferably, the contact segment 254 is at least in a sector of its connecting portion 268 bent out of the geometrical sealing plane 292.

In particular, by the bending the contacting face 264 of the contact segment 254 faces in a different direction than the sealing face 216, 218 of the sealing segment 322, 324 of the same layer 312, 314.

Preferably, the respective sealing face 216, 218 and the respective contacting faces 264 provided by a same layer 312, 314 are for different mating parts of the at least two mating parts 112, 114. For example, here the layer 312 provides the sealing face 216 for the mating part 112 and the contacting faces 264II for the mating part 114 whereas the layer 314 provides the sealing face 218 for the mating part 114 and the contacting faces 2641 for the mating part 112.

In particular, for achieving that the one layer 312, 314 provides the sealing face 216, 218 for one of the mating parts 112, 114 but the contacting faces 264 for the other mating part 114, 112 and that the other layer 314, 312 provides the sealing face 218, 216 for the other mating part 114, 112, but the contacting faces 264 for the one mating part 112, 114, at least the projections of contact segments 2541, 254II of the two layers 312, 314 which are arranged next to each other cross each other in a crossing area 366 of a projection plane, as exemplarily shown in figs. 6 and 7. The projection plane runs in particular at least approximately perpendicular to the geometrical sealing plane 292 and at least approximately perpendicular to a longitudinal course of the sealing section 212 and/or runs through the sealing axis 294 and in particular runs in a radial direction away from the sealing axis 294.

Advantageously, in each case, the sealing face 216, 218 and the contacting faces 264 provided by the same layer 312, 314 are located on different surfaces of the two surfaces 316, 317, 318, 319 of that same layer 312, 314. For example, the sealing face 216 of the layer 312 is provided on the surface 316 and the contacting faces 264II provided by the layer 312 are located on the opposite surface 317 and at the layer 314 the sealing face 218 is provided on the surface 318 and the contacting faces 264I are provided on the opposite surface 319.

Advantageously, the contact segment 254 is bent in its contacting portion 262, such that a curved contacting face 264, in particular as described above, is provided.

In particular, at least one of the layers 312, 314 has several holding segments 372 that build clip elements 274 of the holding structure 276.

In particular, the holding segments 372 are fixedly connected to the sealing segment 322, 324 of the respective layer 312, 314 that has the holding segment 372. Preferably, the holding segment 372 is at least partially bent.

In particular, in this exemplary embodiment the holding segments 372 are built by the contact segments 254, here for example by the contact segments 254I of the layer 314. Accordingly, for preferred details of the design of the holding segment 372 it is fully referred to the explanation provided in connection with the contact segment 254.

In particular, the two layers 312, 314 are fixed to each other preferably by a fixing structure 382.

For example the fixing structure 382 is at least partially built by several fixing segments 384 of one layer 312, 314, here for example of the layer 312, with the fixing segment 384 being folded around a sector of the other layer 314, in particular around a sector of the sealing segment 322, 324 of the other layer 314.

For example, the fixing segment 384 has partially a cut 386 in the sector in which it is folded.

Preferably, the stopper portions 244 are built by the stopper segments 392 of at least one layer 312, 314.

Advantageously, the stopper segment 392 is a folded segment of the layer 312, 314 to increase the thickness of the sealing section 212 in the stopper portions 244.

For example, the fixing segment 384 and the stopper segment 392 are built by the same segment.

In particular, in the stopper portions 244 have essentially a thickness of three times the layer thickness in cases in which the two layers 312, 314 have at least approximately the same layer thickness. The bridging portions 352 and 354 are built such that the two sealing portions 222, 224 of the two layers 312, 314 are distanced to each other in the sealing direction 178. The distance between the two sealing portions 332, 334 is larger than the layer thickness, such that the hollow space 228 between the two sealing elements 222, 224 has in this exemplary embodiment an extent in the sealing direction 178 that is larger than the layer thickness when there is no pressure applied to the sealing section 212.

In particular, the structure and the functionality of the assembly 100 with the gasket 120 and for example advantages thereof are briefly summarized as follows:
The gasket 120 has the sealing section 212 that in particular is formed by at least one sealing segment 322, 324. Preferably, the sealing section 212 has a resilient element 232 and a solid element 236.

The sealing section 212 provides the sealing faces 216, 218 for arranging in a sealed manner to a respective mating part 112, 114. In particular, the sealing faces 216, 218 are opposite arranged to each other and face in opposite directions with respect to the sealing direction 178.

Each of the sealing faces 216, 218 is provided by a respective sealing portion 222, 224. Preferably, sealing portions 222, 224 are resiliently arranged in the sealing section 212.

In particular, at least at the sealing faces 216, 218 there is a coating with a sealing material.

With a coating at the sealing faces a sealing arrangement with the mating part 112, 114 is improved.

In particular, the gasket 120 has the electrically connecting unit 252 with two groups of several contact segments 254. The first group of contact segments 254I is for contacting one of the two mating parts 112, 114 and the second group of contact segments 254II is for contacting the other of the two mating parts 114, 112.

Because each of the contact segments 254 of one group is electrically connected to at least one contact segment 254 of the other group, in a mounted state the two mating parts 112, 114 are electrically connected to each other through the electrically connecting unit 252.

In particular, the electrical connection between the two mating parts 112, 114 by the electrically connecting unit 252 provides an electromagnetic compatible assembly. For example, an undesired electrostatic charging of one of the mating parts 112, 114 is at least reduced used due to their electrical connection through the electrically connecting unit 252.

Because the sealing is at the sealing faces 216, 218 and the electrical connection is through the contacting faces 264 each of the different faces 216, 218, 264 can be optimized separately for their specific function. In particular, the sealing material can be optimized for a better sealing regardless whether the sealing material is electrically conductive or not. In particular, most preferred sealing materials are isolators. The contacting faces 264 are optimized for a good electrical contact and are for example metallic faces.

Advantageously, the gasket 120 is built by several, for example two, layers 312 and 314. In particular, then the sealing segments 322, 324 and the contact segments 254 are formed by a respective layer 312, 314.

Advantageously, on one surface 316, 318 of two opposite surfaces 316, 317, 318, 319 such a layer 312, 314 is at least partially at the sealing face 216, 218 coated and for example on that surface 316, 318 fully coated.

On the other surface 317, 319 of the opposite surfaces 316, 317, 318, 319 the layer 312, 314 has preferably no coating. Advantageously, the contacting face 264 of the layer 312, 314 is provided on the surface 317, 319 without a coating.

In particular, therewith in a constructively simple manner coated sealing faces 316, 318 and good electrically conductive contacting faces 264 can be provided by the layers 312, 314.

In particular, one of the two layers 312, 314 provides the contacting faces 264I for one of the two mating parts 112, 114 and the other layer 312, 314 provides the contacting faces 264II for the other of the two mating parts 112, 114. Advantageously, because the two layers 312, 314 lie at least at their attaching portions 342, 344 with their uncoated surfaces 317, 319 on each other, they are in electrically conductive manner connected to each other and so are their contacting faces 264I and 264II.

In particular, the layers 312, 314 are formed and arranged such that one of the two layers 312 provides the sealing face 216 for one of the two mating parts 112, 114 but the contacting faces 264II for the other of the two mating parts 112, 114 and the other layer 314 provides the sealing face 218 for the other of the two mating parts 114, 112 but the contacting faces 264I for the one mating part 112, 114.

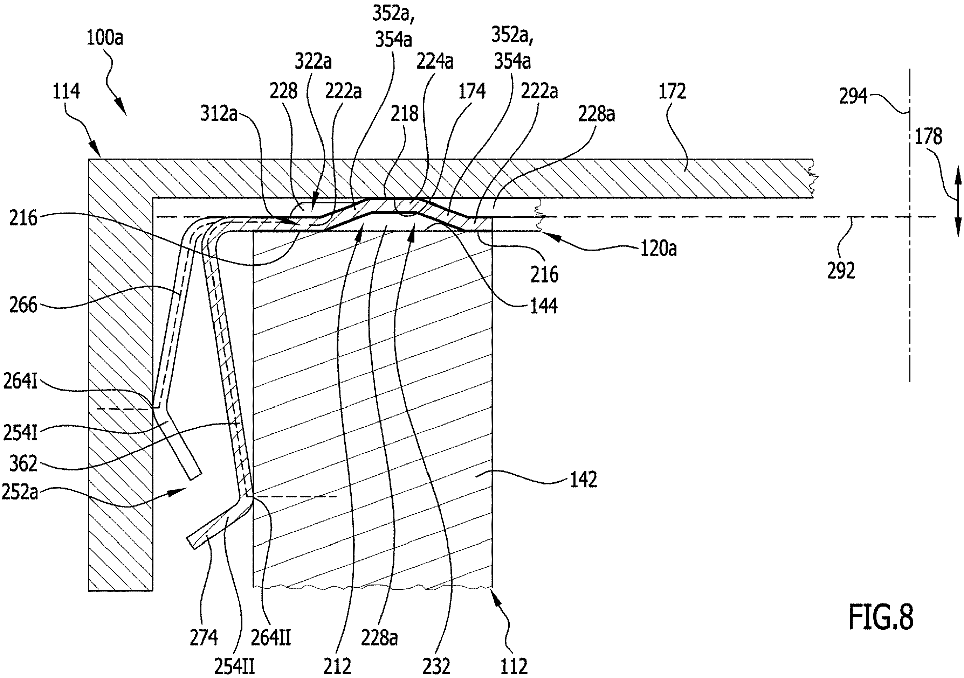

In connection with the description of further exemplary embodiments, which are exemplarily shown in figs. 8 to 14, elements and/or features that are at least basically the same and/or fulfill at least basically the same function are before and subsequently provided with the same reference sign.

In particular, if special reference is made to a configuration in an exemplary embodiment, a letter referring to the corresponding exemplary embodiment is appended as a suffix to the respective reference sign.

Regarding the more detailed description of elements and of features of an embodiment it is fully referred to the description of the other embodiments, for example the previously and/or one of the following described exemplarily embodiments, except a particular described detail is clearly not compatible with the one embodiment.

In an exemplary embodiment a gasket 120a for sealing between two mating parts 112, 114 within an assembly 100a is provided, wherein the gasket 120a has a single layer 312a. Exemplarily a gasket 120a with a single layer 312a is shown in fig. 8.

In particular, the single layer 312a has a single sealing segment 322a which provides the sealing faces 216, 218 for the two mating parts 112, 114.

In particular, the sealing segment 322a is coated with a sealing material at least at the sealing faces 216, 218. For example, the single sealing segment 322a is fully coated on at least one of, for example on both of, its opposite surface regions.

In particular, the single sealing segment 322a has at least one sealing portion 222a providing the sealing face 216 and at least one other sealing portion 224a providing the other sealing face 218. In particular, the respective sealing portion 222a and 224a are fixedly connected to each other by a bridging portion 352a, 354a.

Preferably, the bridging portion 352a, 354a is built such that the connected sealing portions 222a and 224a are in the sealing direction 178 offset to each other.

In particular, the sealing segment 322a is built such that at the sealing portions 222a, 224a there is a hollow space 228a on a side opposite to the side on which the sealing face 216, 218 is provided. For example, this is achieved by the bridging portion 352a, 354a connecting respective sealing portions 222a, 224a with an offset. In particular, the sealing portions 222a, 224a are resiliently arranged with respect to each other and form a resilient element 232 of the sealing section 212, in particular of the single sealing segment 322a.

For example, the sealing segment 322 provides for at least one mating part, here for the mating part 112, two sealing faces 216.

Preferably, the single sealing segment 322a comprises a bead at which the sealing faces 216, 218 are provided. In particular, the bead is built by the sealing portions 222a, 224a and the bridging portions 352a, 354a.

In some variants the bead is a full bead. In some variants there are two half beads, as exemplarily shown in fig. 8. In yet other variants there is only one half bead. In some variants the bead has essentially straight portions which are connected at edge like transitions and in some variants portions of the bead are curved. For example, for variants of possible beads it is referred to subsequently described embodiments.

Preferably, the gasket 120a has in the sealing section 212 a stopper structure 242 which in particular comprises at least one stopper portion 244.

In particular, the stopper structure 242 is at least partially built by a stopper segment 392. In particular, at the stopper segment 392 a sector of the stopper segment is folded over on to another sector of the stopper segment 392.

The gasket 120a has an electrically connecting unit 252a with contact segments 254I and 254II of the single layer 312a. The contact segments 254 provide contacting faces 264 for the two mating parts 112, 114.

In particular, the contacting faces 264 are electrically conductive faces and/or metallic faces. In particular, the contacting faces 264 are not coated and preferably the entire contact segments 254 are at least essentially not coated.

In particular, the contact segments 254a of the gasket 120a are at least similarly built like it is described in connection with the previous embodiment except for that the contact segments 254a are formed by the single layer 312a and not built by several layers 312, 314. Exemplarily this is shown in fig. 8. For example, in such variants the contacting faces 264 face in a different direction than the sealing faces 218, 216 and/or the contact segments 254 extend away from the sealing segment 322a in particular out of the sealing plane 292 and/or away at least approximately in the sealing direction 178.

In some variants, the contact segments 254a of the single layer 312a are at least similarly built as described in connection with the subsequently described embodiments except for that the contact segments 254a are formed by the single layer 312a and not built by several layers 312, 314. For example, in such variants the contacting faces 264 are facing at least approximately in the same direction as the respective sealing faces 216, 218 and/or the contact segments 254 extent at least approximately within the geometrical sealing plane 292.

In some exemplary embodiments of a gasket 120b,c,d for mating parts 112, 114 of an assembly 100b,c,d, the gasket 120b,c,d has contacting faces 264 which face at least approximately in a similar direction like sealing faces 216, 218 of the gasket 120b,c,d. As far as these exemplary embodiments are at least similarly built they are described together.

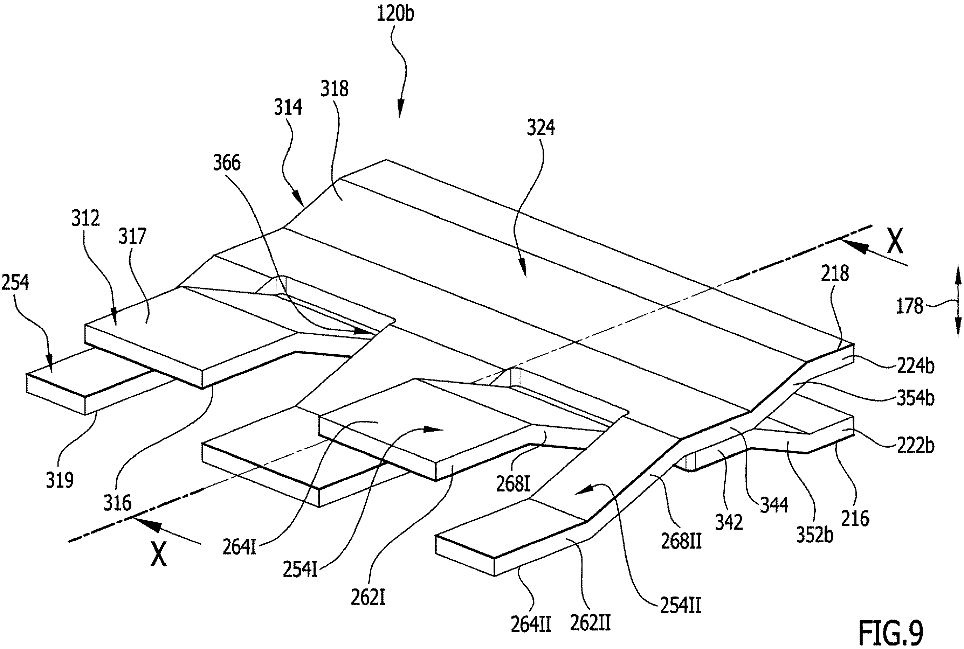

Exemplarily, gaskets 120b,c,d and assemblies 100b,c,d are shown in figs. 9 to 14.

In particular, the contact segments 254b,c,d of these embodiments are designed such that their respective contacting face 264 contacts a surface of the respective mating parts 112, 114 that provides the to be sealed face 144, 174, too.

In particular, the contacting faces 264I,b,c,d for the mating part 112 and the sealing face 216 for the same mating part 112 extend at least essentially in a same geometrical plane which is at least approximately parallel to the sealing plane 292. In particular, the contacting faces 264IIb,c,d for the other mating part 114 and the sealing face 218 for the same other mating part 114 extend at least essentially in a same geometrical plane that is at least approximately parallel to the geometrical sealing plane 292.

In particular, the contact segments 254b,c,d and the sealing section 212 are in these exemplary embodiments in a mounted state arranged in a same gap 176 between the mating parts 112, 114.

In particular, two layers 312, 314 of the gasket 120b,c,d have each a sealing face 216, 218 and contacting faces 264. The sealing face 216, 218 on the one hand and the contacting faces 264 on the other hand of the same layer 312, 314 are facing at least essentially in opposite directions in particular with respect to the sealing direction 178.

In particular, one of the layers, here for example the layer 312, provides the sealing face 216 for one of the two mating parts, here for the mating part 112, and the contacting faces 264II of the second group for the other mating part, here for the mating part 114, whereas another layer, here the layer 314, provides the sealing face 218 for the other mating part, here the mating part 114, and the contacting faces 264I of the first group for the one mating part, here the mating part 112.

In particular, the layers 312 and 314 are arranged between the mating parts 112, 114 such that the one surface, here the surface 316, 318, respectively, that is at least partially, for example fully coated, faces in direction towards one of the mating parts 112, 114 and provides the respective sealing face 216, 218 whereas the other surface, here for example the surface 217, 219, respectively, that is uncoated, faces in the direction of the other mating part 114, 112 and provides the respective contacting faces 264.

Advantageously, the contact segments 254I,II of the gaskets 120b,c,d have respective connecting portions 268I and 268II. The projections of that connecting portions 268 cross each other in a crossing area 366 such that advantageously a respective layer 312, 314 can provide the sealing faces 216, 218 for one mating part 112, 114 but the contacting faces 264 for the other mating part 114, 112.

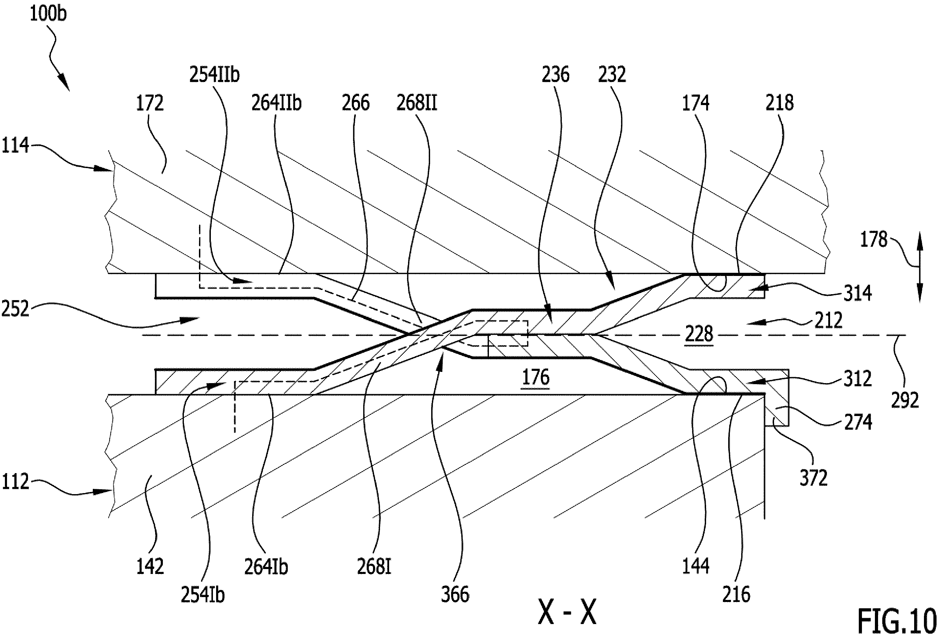

For example, the sealing segment 322, 324 of at least one layer 312, 314 comprises a half bead like for example the gasket 120b which is exemplarily shown in figs. 9 and 10.

For example, the sealing portion 222b, 224b is connected to another portion of the sealing segment 322, 324, for example to an attaching portion 342, 344, by a bridging portion 352, 354. Depending on the variant, the portions extend essentially straight like exemplarily shown in figs. 9 and 10 or are curved portions.

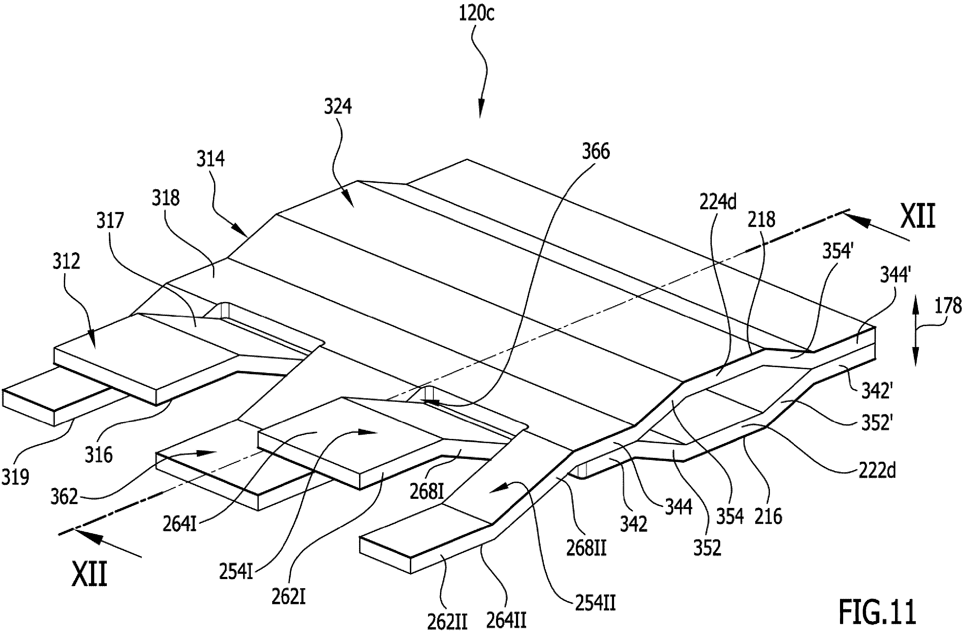

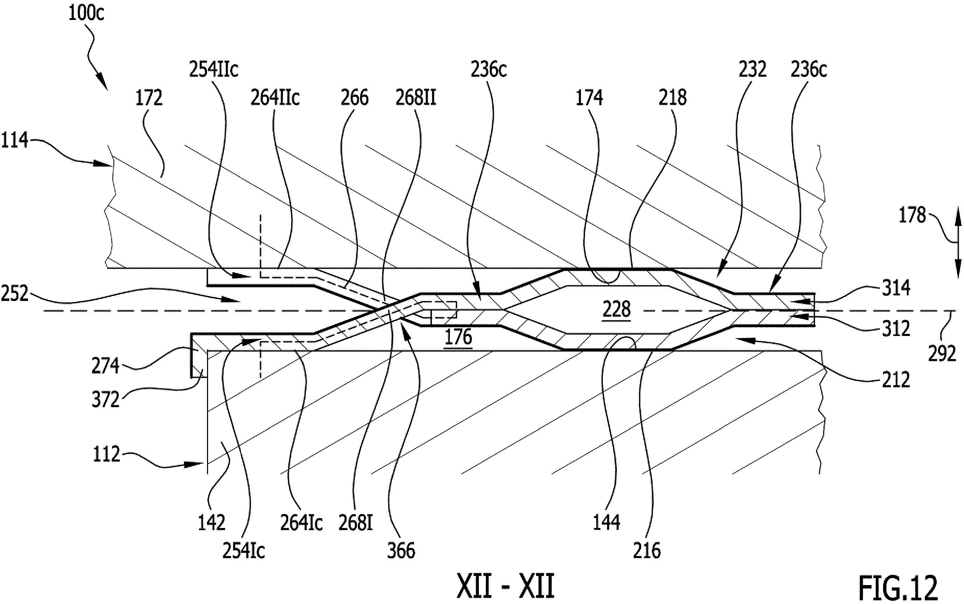

In some embodiments the gasket 120c has two solid elements 236c and in particular between the two solid elements 236 the resilient element 232 with the sealing faces 216, 218 is arranged, as exemplarily shown in figs. 11 and 12.

For example, the sealing portion 222d, 224d is connected at each longitudinal side with a bridging portion 352, 354 and 352', 354' and preferably connected by the respective bridging portion 352, 354, 352', 354' to another portion, in particular a respective attaching portion 342, 344 and 342', 344' of the sealing segment 322, 324.

Preferably, the sealing portion 222, 224 together with the respective bridging portion 352, 354, 352', 354' and the further portion build a half bead and therefore the respective sealing segment 322, 324 has a double half bead structure.

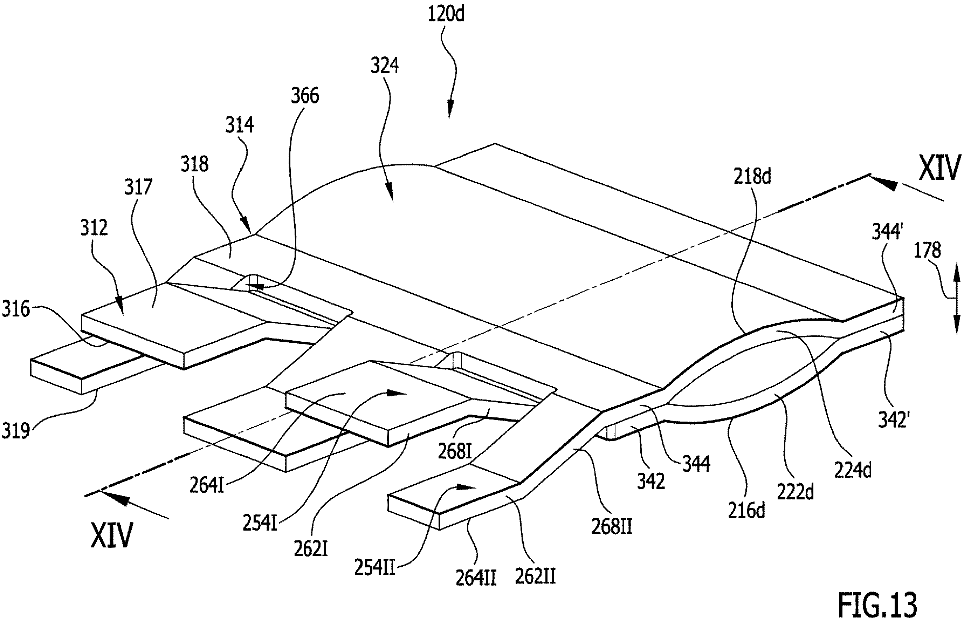

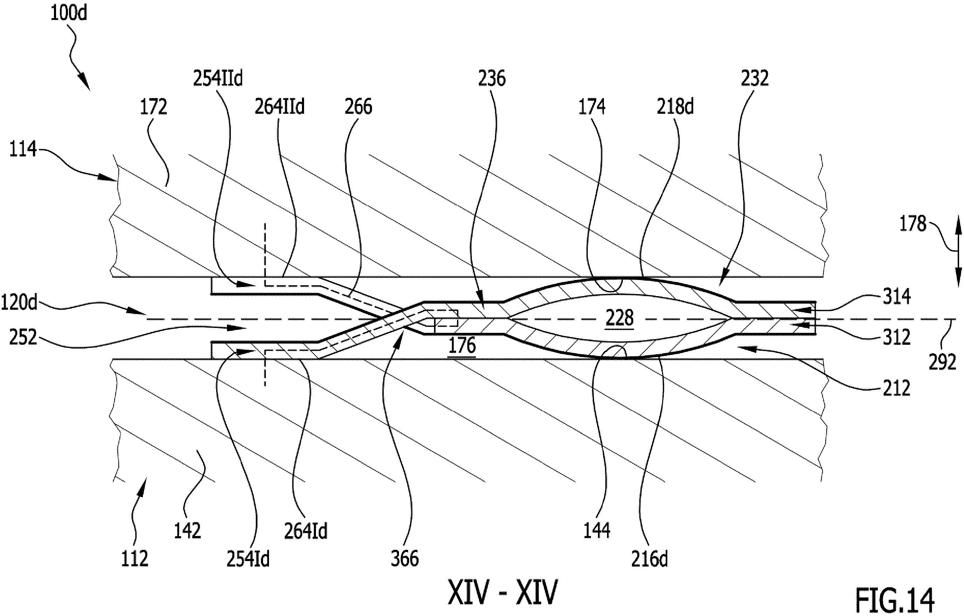

In some preferred exemplary embodiments, at least one sealing face 216, 218 is a curved sealing face as exemplarily shown in connection with the gasket 120d in figs. 13 and 14. In some preferred variants of the other embodiments a curved sealing face 216, 218 is provided, too.

For example, along two longitudinal sides the sealing portions 222d, 224d with the curved sealing face 216d, 218d is connected to another portion, for example to a respective attaching portion 342, 344, 342', 344' of the sealing segment 322, 324.

In particular, the sealing portion 222d, 224d with a curved sealing face 216d, 218d is curved with respect to a cross section taken transverse to its longitudinal extension.

In particular, the sealing segment 322, 324 of the gasket 120d has a full bead structure.

Preferably, the gasket 120b,c,d has a stopper structure 242, that is for example built by a stopper segment 292, that is in particular at least partially built as described previously.

Advantageously, the gasket 120b,c,d comprises a fixing structure 382, that in particular comprises fixing segments 384, that is preferably at least partially built as described previously.

In some preferred variants the gasket 120b,c,d comprises a holding structure 246 in particular with clip elements 274.

Exemplarily, in figs. 10 and 12 variants of clip elements 274 are shown.

In particular, the clip elements 274 are projecting away from a sealing face 216, 218 or away from a contacting face 264 such that the clip elements 274 can engage one of the mating parts 112, 114, in particular can engage with an edge of the mating part 112, 114.

Preferably, a respective clip element 274 is built by a holding segment 372 of at least one layer 312, 314.

For example, at least one holding segment 372 is, in particular directly, connected to the sealing segment 322, 324 of the layers 312, 314 and for example connected to the sealing portion 222, 224 as exemplarily shown in fig. 10.

For example, at least one holding segment 372 is, in particular directly, connected to a contact segment 254 of the layer 312, 314, as exemplarily shown in fig. 12.

In other variants, the holding structure 276 is and in particular the clip elements 274 are at least partially built as described previously.

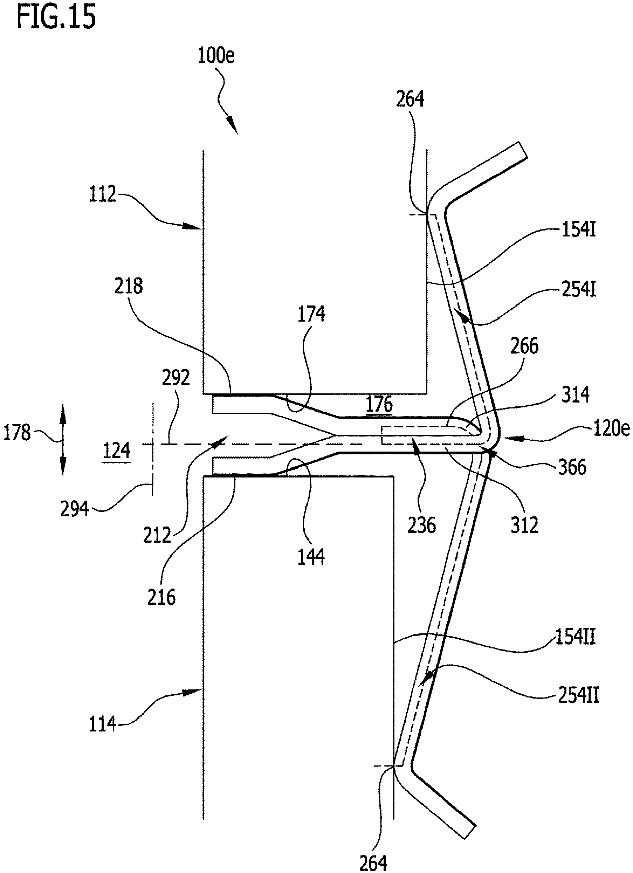

A variant of yet another exemplary embodiment of a gasket 120e for mating parts 112, 114 of an assembly 100e is exemplarily shown in fig. 15.

In particular, in this embodiment, the contacting faces 264 of the contact segments 254I of the first group are contacting the respective mating part 112 at an outer wall section face 154I of this mating part 112 and the contacting faces 264 of the contact segments 254II of the second group are contacting the respective mating part 114 at an outer wall section face 154II of this mating part 114.

In particular, in this embodiment the contact segments 254I of the first group and the contact segment 254II of the second group are extending opposite each other and in particular they are extending away from the sealing plane 292 at least approximately in opposite directions.

At least a contact segment 254I of the first group and a contact segment 254II of the second group which are arranged next to each other cross each other, at least in the sense that the projections of these contact segments 254 in a projection plane cross each other in this projection plane.

In preferred variants of the embodiment the contact segments 254 are at least partly, for example at least essentially, built in a same manner like in the first embodiment except for that the contacting segment 254 of at least one group are configured that their contacting faces 264 contact another section, in particular a face of an outer wall section, of the respective mating part instead of an overlapping section and/or with the contact segment 254I of the first group and the contact segment 254II of the second group are extending opposite each other.

In other variants of the embodiments the contact segments 254 are at least partly built as described in connection with any of the other described embodiments.

The gasket 120e of this embodiment has a sealing section 212. Preferably, the sealing section 212 is at least partly, for example at least essentially, built as described in connection with any of the other embodiments and/or the sealing section 212 has a combination of features as described in connection with any of the other embodiments.

In particular, as far as one of the exemplary embodiments described above is not described in all of its details, preferably, at least some elements and/or features are built as described in connection with another embodiment such that respective passages of the description provide variants of the other embodiments.

In particular, features and/or elements described in connection with separate exemplary embodiments are interchangeable and combinable with elements and/or features of other embodiments, except a replacement and/or combination is clearly technically incompatible.

In further advantageous exemplary embodiments, features and/or elements described previously in connection with separate exemplary embodiments are combined.

### REFERENCE NUMERALS

- 100: assembly
- 112: mating part
- 114: mating part
- 120: gasket
- 122: housing
- 124: interior
- 132: joining side
- 134: joining side
- 142: outer wall
- 144: to be sealed face
- 148: housing opening
- 152: inner wall section face
- 154: outer wall section face
- 158: front side
- 162: end surface
- 166: inner edge section
- 168: outer edge section
- 172: outer wall
- 174: to be sealed face
- 176: gap
- 178: sealing direction
- 182: wall section
- 188: free space
- 192: overlapping area
- 212: sealing section
- 216: sealing face
- 218: sealing face
- 222: sealing portion
- 224: sealing portion
- 228: hollow space
- 232: resilient element
- 236: solid element
- 242: stopper structure
- 244: stopper portion
- 252: electrically connecting unit
- 254: contact segment
- 262: contacting portion
- 264: contacting face
- 266: electrical path
- 268: connecting portion
- 274: clip element
- 276: holding structure
- 292: sealing plane
- 294: sealing axis
- 312: layer
- 314: layer
- 316: surface
- 317: surface
- 318: surface
- 319: surface
- 322: sealing segment
- 324: sealing segment
- 342: attaching portion
- 344: attaching portion
- 352: bridging portion
- 354: bridging portion
- 366: crossing area
- 372: holding segment
- 382: fixing structure
- 384: fixing segment
- 386: cut
- 392: stopper segment

## Claims

1. Gasket (120), in particular gasket (120) for an electrical assembly and/or an automotive assembly, for sealing between at least two mating parts (112, 114), wherein the gasket (120) comprises a sealing section (212) and at least one electrically connecting unit (252), wherein the sealing section (212) comprises a first group of at least one sealing face (216, 218) for one of the at least two mating parts (112, 114) and a second group of at least one sealing face (216, 218) for the other of the at least two mating parts (112, 114) and wherein the at least one electrically connecting unit (252) comprises a first group of at least one electrically conductive contacting face (264) for the one of the two mating parts (112, 114) and a second group of at least one electrically conductive contacting face (264) for the other of the at least two mating parts (112, 114), wherein at least one sealing face (216, 218) of the first group and at least one electrically conductive contacting face (264) of the first group are different faces and/or at least one sealing face (216, 218) of the second group and at least one electrically conductive contacting face (264) of the second group are different faces.

2. Use of a gasket (120) for sealing between at least two mating parts (112, 114) and electrically connecting the at least two mating parts (112, 114), wherein the gasket (120) comprises a sealing section (212) for sealing between the at least two mating parts (112, 114) and at least one electrically connecting unit (252) for electrically connecting the at least two mating parts (112, 114), wherein the sealing section (212) comprises a first group of at least one sealing face (216, 218) for one of the two mating parts (112, 114) and a second group of at least one sealing face (216, 218) for the other of the at least two mating parts (112, 114) and wherein in use the at least one sealing face (216, 218) of the first group is arranged in a sealed manner with the one of the at least two mating parts (112, 114) and the at least one sealing face (216, 218) of the second group is arranged in a sealed manner with the other of the at least two mating parts (112, 114) and wherein the electrically connecting unit (252) comprises a first group of at least one electrically conductive contacting face (264) for one of the two mating parts (112, 114) and a second group of at least one electrically conductive contacting face (264) for the other of the at least two mating parts (112, 114) and wherein in use the at least one electrically conductive contacting face (264) of the first group is arranged in electrically conductive contact with the one of the at least two mating parts (112, 114) and the at least one electrically conductive contacting face (264) of the second group is arranged in an electrically conductive contact with the other of the at least two mating parts (112, 114) and wherein at least one sealing face (216, 218) of the first group and at least one electrically conductive contacting face (264) of the first group are different faces and/or at least one sealing face (216, 218) of the second group and at least one electrically conductive contacting face (264) of the second group are different faces.

3. Assembly (100), in particular an electrical assembly and/or an automotive assembly, comprising at least two mating parts (112, 114) and a gasket (120) in accordance with claim 1, wherein at least one sealing face (216, 218) of the first group is in sealing arrangement with one of the at least two mating parts (112, 114) and at least one sealing face (216, 218) of the second group is in sealing arrangement with the other of the at least two mating parts (112, 114) and wherein at least one electrically conductive contacting face (264) of the first group is in electrically conductive contact with the one of the at least two mating parts (112, 114) and at least one electrically conductive contacting face (264) of the second group is in electrically conductive contact with the other of the at least two mating parts (112, 114).

4. Gasket (120) according to claim 1 and/or use according to claim 2 and/or assembly (100) according to claim 3, wherein at least one sealing face (216, 218) of the first group is coated with a sealing material and/or at least one sealing face (216, 218) of the second group is coated with a sealing material,
wherein in particular the sealing material comprises an elastomer, in particular comprises a natural and/or synthetic rubber.

5. Gasket (120) and/or use and/or assembly (100) according to one of the preceding claims,
- wherein at least one contacting face (264) of the first group and/or at least one contacting face (264) of the second group is made of an electrically conductive material and/or is in particular a metallic face,
and/or
- wherein at least one contacting face (264) is a curved face.

6. Gasket (120) and/or use and/or assembly (100) according to one of the preceding claims, wherein within the gasket (120) there is at least one electrically conductive path (266) between at least one contacting face (264) of the first group and at least one contacting face (264) of the second group,
- wherein in particular each contacting face (264) of each of the first and second group is electrically connected with at least one contacting face (264) of the other group by an electrically conductive path (266),
- wherein in particular at least one electrically conductive path (266) runs at least partially through the sealing section (212).

7. Gasket (120) and/or use and/or assembly (100) according to one of the preceding claims, with at least one of the following
- wherein at least one contact segment (254) that provides at least one contacting face (264) is fixedly connected with the sealing section (212)
and/or
- wherein at least one contact segment (254) that provides at least one contacting face (264) for one of the at least two mating parts (112, 114) is fixedly connected with a sealing segment of the sealing section (212), that sealing segment provides at least one sealing face (216, 218) for the other of the at least two mating parts and/or
- wherein at least one contact segment (254) that provides at least one contacting face (264) is integrally formed with at least a segment of the sealing section (212)
and/or
- wherein at least one contact segment (254) that provides at least one contacting face (264) for one of the at least two mating parts (112, 114) is integrally formed with a sealing segment of the sealing section (216, 218), that sealing segment provides at least one sealing face (216, 218) for the other of the at least two mating parts (112, 114).

8. Gasket (120) and/or use and/or assembly (100) according to one of the preceding claims, wherein the contacting faces (264) of the connecting unit (252) are arranged along the sealing section (212) with an offset to each other.

9. Gasket (120) and/or use and/or assembly (100) according to one of the preceding claims,
- wherein at least one contact segment (254), that provides at least one contacting face (264), is resiliently arranged, in particular with respect to the sealing section (212) resiliently arranged
and/or
- wherein at least one contact segment (254) that provides at least one contacting face (264) of the first group and at least one contact segment (254) that provides at least one contacting face (264) of the second group are resiliently arranged with respect to each other.

10. Gasket (120) and/or use and/or assembly (100) according to one of the preceding claims, with at least one of the following
- wherein at least one contacting face (264) of the first group and at least one sealing face (216, 218) of the first group are facing in different directions and/or wherein at least one contacting face (264) of the second group and at least one sealing face (216, 218) of the second group are facing in different directions
and/or
- wherein at least one contacting face (264) is arranged outside of a sealing plane (292), wherein in particular the sealing plane (292) is defined by at least a subsection of the sealing section (292) and/or
- wherein at least one contacting face (264) of the gasket (120) is at least configured for contacting an overlapping section (182) of one mating part (112, 114), wherein in particular the overlapping section (182) at least partly overlaps with a section of the other mating part and/or at least partly overlaps a gap (176) between the at least two mating parts (112, 114)
and/or
- wherein at least one contacting face (264) of the first group and at least one sealing face (216, 218) of the first group are facing in at least approximately the same direction and/or wherein at least one contacting face (264) of the second group and at least one sealing face (216, 218) of the second group are facing in at least approximately the same direction.

11. Gasket (120) and/or use and/or assembly (100) according to one of the preceding claims, wherein the sealing section (212) comprises at least one resilient element (232)
- in particular wherein at least one resilient element (232) of the sealing section (212) provides at least one sealing face (216, 218), in particular at least one sealing face (216, 218) of the first group and/or at least one sealing face (216, 218) of the second group and/or
- in particular wherein at least one resilient element (232) of the sealing section (212) has at least one hollow space (228) adjacent to a sealing portion (222, 224) of the resilient element (232), wherein that sealing portion (222, 224) provides at least one sealing face (216, 218)
and/or
- in particular wherein at least one resilient element (232) of the sealing section (212) has a hollow space (228) between a sealing portion (222, 224) of the resilient element (232), that sealing portion (222, 224) provides a sealing face (216, 218) of the first group, and a sealing portion (222, 224) of the resilient element (232), that sealing portion (222, 224) provides a sealing face (216, 218) of the second group.

12. Gasket (120) and/or use and/or assembly (100) according to one of the preceding claims, with at least one of the following
- wherein the gasket (120), in particular its sealing section (212), comprises at least one stopper structure (242) which in particular prevents a too strong deformation of the resilient element (232) and/or
- wherein the sealing section (212) comprises at least one solid element (236), wherein in particular within the solid element (236) there is material of the sealing section (216, 218) throughout between opposing face regions of the solid element (236) and/or
- wherein the gasket (120) comprises at least one holding structure (228) for holding the gasket (120) in place with respect to at least one of the two mating parts
and/or
- wherein the holding structure (228) is built at least partly by at least one contact segment (254) of the connecting unit (252).

13. Gasket (120) and/or use and/or assembly (100) according to one of the preceding claims, wherein the gasket (120) comprises at least one layer (312, 314),
wherein in particular the gasket (120) comprises at least two layers (312, 314).

14. Gasket (120) and/or use and/or assembly (100) according to one of the preceding claims, with at least one of the following:
- wherein at least one layer (312, 314) of the gasket (120) provides at least one sealing face (216, 218) for one of the at least two mating parts (112, 114) and at least one contacting face (264) for the other of the at least two mating parts (112, 114)
and/or
- wherein at least one sealing face (216, 218) of the first group and/or at least one contacting face (264) of the second group is/are provided by one layer (312, 314) of the gasket (120) and at least one sealing face (216, 218) of the second group and/or at least one contacting face (264) of the first group is/are provided by another layer (312, 314) of the gasket (120)
and/or
- wherein at at least one layer (312, 314) on one of two opposite surfaces (316, 317, 318, 319) of that at least one layer (312, 314) at least one sealing face (216, 218) is provided and on the other of the two opposite surfaces (316, 317, 318, 319) of that at least one layer (312, 314) at least one contacting face (264) is provided.

15. Gasket (120) and/or use and/or assembly (100) according to one of the preceding claims, with at least one of the following:
- wherein at least one layer of the gasket (120) is on one of its surfaces (316, 317, 318, 319) at least essentially fully coated and/or
- wherein at least two layers (312, 314) of the gasket (120) are electrically connected to each other
and/or
- wherein at least two layers (312, 314) of the gasket (120) lie at least partly on each other, in particular lie with electrically conductive faces on each other and/or their portions lying on each other build at least partly the solid element (236) of the gasket (120)
and/or
- wherein at least one layer (312, 314) of the gasket (120), in particular at least two layers (312, 314) of the gasket (120) forms/form at least partly the resilient element (232) of the sealing section (212).
